(19) **Europäisches Patentamt European Patent Office Office européen des brevets**

(11) **EP 4 475 412 B1**

(12) **EUROPEAN PATENT SPECIFICATION**

(45) Date of publication and mention of the grant of the patent:
**01.07.2026 Bulletin 2026/27**

(21) Application number: **23784112.7**

(22) Date of filing: **28.02.2023**

(51) International Patent Classification (IPC):
*G01R 31/26* (2020.01)   *H02M 1/08* (2006.01)
*H02M 1/32* (2007.01)   *H02M 7/5387* (2007.01)

(52) Cooperative Patent Classification (CPC):
**H02M 1/32; G01R 31/2621; H02M 1/08; H02M 7/53873;** Y02B 70/10

(86) International application number:
**PCT/CN2023/078880**

(87) International publication number:
**WO 2023/193548 (12.10.2023 Gazette 2023/41)**

(54) **SWITCHING TRANSISTOR TURN-OFF NEGATIVE VOLTAGE DETERMINATION METHOD AND APPARATUS, INVERTER, COMPUTER-READABLE STORAGE MEDIUM, AND SWITCHING TRANSISTOR DRIVE CONTROL CIRCUIT**

VERFAHREN UND VORRICHTUNG ZUR BESTIMMUNG DER NEGATIVEN ABSCHALTSPANNUNG EINES SCHALTTRANSISTORS, WECHSELRICHTER, COMPUTERLESBARES SPEICHERMEDIUM UND SCHALTTRANSISTOR-ANSTEUERUNGSSTEUERSCHALTUNG

PROCÉDÉ ET APPAREIL DE DÉTERMINATION DE LA TENSION NÉGATIVE DE COUPURE D'UN TRANSISTOR À COMMUTATION, ONDULEUR, SUPPORT DE STOCKAGE LISIBLE PAR ORDINATEUR ET CIRCUIT DE COMMANDE DE TRANSISTOR À COMMUTATION

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **06.04.2022 CN 202210360280**

(43) Date of publication of application:
**11.12.2024 Bulletin 2024/50**

(73) Proprietors:
• **Anhui Welling Auto Parts Corporation Limited**
  **Hefei, Anhui 230088 (CN)**
• **Guangdong Welling Auto Parts Corporation Limited**
  **Foshan, Guangdong 528311 (CN)**

(72) Inventors:
• **SHI, Hongkang**
  **Hefei, Anhui 230088 (CN)**
• **LI, Junlong**
  **Hefei, Anhui 230088 (CN)**
• **QIN, Feixiang**
  **Hefei, Anhui 230088 (CN)**

(74) Representative: **RGTH Patentanwälte PartGmbB Mönckebergstraße 11 20095 Hamburg (DE)**

(56) References cited:
CN-A- 109 450 233   CN-A- 109 586 555
CN-A- 109 831 197   CN-A- 109 831 197
CN-A- 111 342 642   CN-A- 112 737 312
CN-A- 114 744 857   US-A1- 2021 021 258
US-A1- 2021 021 258

**Description**

**CROSS-REFERENCE TO RELATED APPLICATION**

This application claims priority to Chinese Patent Application No. 202210360280.1, titled "METHOD AND APPARATUS FOR DETERMINING TURN-OFF VOLTAGE OF SWITCHING TRANSISTOR, AND SWITCHING TRANSISTOR DRIVE CONTROL CIRCUIT", and filed on April 06, 2022.

**FIELD**

The present disclosure relates to the field of inverter technologies, and more particularly, to a method and an apparatus for determining a turn-off negative voltage of a switching transistor, and a switching transistor drive control circuit.

**BACKGROUND**

With the gradual improvement of the living standard of people, more and more vehicles enter thousands of households to provide convenience for t raveling. In the related art, a silicon-carbide Metal Oxide Semiconductor (MOS) transistor is used in vehicle compressor inverter system of a high input voltage to reduce loss and improve efficiency of the inverter. However, the silicon-carbide MOS transistor has the problem of being easily turned on mistakenly. CN 109 831 197 A provides a gate turn-off control method and device for a silicon carbide field effect transistor and a driving circuit of the silicon carbide field effect transistor, so as to adopt a scientific and reasonable gate turn-off voltage to the silicon carbide field effect transistor.

**SUMMARY**

The present disclosure aims to solve one of the technical problems in the related art at least to some extent. To this end, the present invention is to provide a processor-implemented method for determining a turn-off negative voltage of a switching transistor, which can accurately determining a turn-off negative voltage interval of the switching transistor. Therefore, when a negative voltage turn-off control is performed on the switching transistor by using the turn-off negative voltage interval, the switching transistor can be effectively prevented from being turned on mistakenly, and the switching transistor can be protected, which can prolong service life of the switching transistor.
The present invention is further to provide an apparatus for determining a turn-off negative voltage of a switching transistor.
The present invention is further to provide an inverter.
The present invention is further to provide a computer-readable storage medium.
The present invention is further to provide a switching transistor drive control circuit.
The present invention is further to provide a motor control system.
The present invention is further to provide a compressor.
The present invention is further to provide a vehicle.
The present invention provides a processor-implemented method for determining a turn-off negative voltage of a switching transistor. The method comprises: determining a first turn-off negative voltage model and a second turn-off negative voltage model; acquiring a turn-off gate resistance and a turn-on gate resistance of the switching transistor, a bus voltage, and a minimum turn-on voltage and a maximum bearable negative voltage absolute value of the switching transistor; inputting the turn-off gate resistance, the turn-on gate resistance, the bus voltage, and the minimum turn-on voltage into the first turn-off negative voltage model to obtain a turn-off negative voltage upper limit absolute value of the switching transistor, and inputting the turn-off gate resistance, the turn-on gate resistance, the bus voltage, and the maximum bearable negative voltage absolute value into the second turn-off negative voltage model to obtain a turn-off negative voltage lower limit absolute value of the switching transistor; and determining a turn-off negative voltage interval of the switching transistor based on the turn-off negative voltage upper limit absolute value and the turn-off negative voltage lower limit absolute value.
In the method for determining the turn-off negative voltage of the switching transistor according to the embodiments of the present disclosure, the turn-off negative voltage upper limit absolute value of the switching transistor is obtained by inputting the acquired turn-off gate resistance, turn-on gate resistance, bus voltage, and minimum turn-on voltage of the switching transistor into the first turn-off negative voltage model, and the turn-off negative voltage lower limit absolute value of the switching transistor is obtained by inputting the acquired turn-off gate resistance, turn-on gate resistance, bus voltage, and maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when a negative voltage turn-off control is performed on the switching transistor by using the turn-off negative voltage interval, the switching transistor can be effectively prevented from being turned on mistakenly, and the switching transistor can be protected, which can prolong service life of the switching transistor.

In some embodiments of the present disclosure, the first turn-off negative voltage model is expressed as $V_{SS\_min}=\lambda_1*f_1(R_{G\_on}, R_{G\_off}, V_{DC})-V_{th}$, where $V_{SS\_min}$ represents the turn-off negative voltage upper limit absolute value, $\lambda_1$ represents a first derating parameter, $f_1(R_{G\_on}, R_{G\text{-}off}, V_{DC})$ represents a function expression corresponding to the first turn-off negative voltage model, $R_{G\_on}$ represents the turn-on gate resistance, $R_{G\_off}$ represents the turn-off gate resistance, $V_{DC}$ represents the bus voltage, and $V_{th}$ represents the minimum turn-on voltage.

In some embodiments of the present disclosure, the second turn-off negative voltage model is expressed as $V_{SS\_max}=V_{GS\_max}-\lambda_2*f_2(R_{G\_on}, R_{G\_off}, V_{DC})$, where $V_{SS\_max}$ represents the turn-off negative voltage lower limit absolute value, $\lambda_2$ represents a second derating parameter, $f_2(R_{G\_on}, R_{G\_off}, V_{DC})$ represents a function expression corresponding to the second turn-off negative voltage model, $R_{G\_on}$ represents the turn-on gate resistance, $R_{G\_off}$ represents the turn-off gate resistance, $V_{DC}$ represents the bus voltage, and $V_{GS\_max}$ represents the maximum bearable negative voltage absolute value.

In some embodiments of the present disclosure, the determining the turn-off negative voltage interval of the switching transistor based on the turn-off negative voltage upper limit absolute value and the turn-off negative voltage lower limit absolute value comprises: setting a negative value of the turn-off negative voltage upper limit absolute value as a turn-off negative voltage upper limit voltage, and setting a negative value of the turn-off negative voltage lower limit absolute value as a lower limit voltage of the turn-off negative voltage; and determining the turn-off negative voltage interval based on the upper limit voltage of the turn-off negative voltage and the lower limit voltage of the turn-off negative voltage.

In some embodiments of the present disclosure, the switching transistor is a silicon-carbide Metal Oxide Semiconductor (MOS) transistor.

The present invention further provides an apparatus for determining a turn-off negative voltage of a switching transistor. The apparatus comprises: a first determining module configured to determine a first turn-off negative voltage model and a second turn-off negative voltage model; an acquiring module configured to acquire a turn-off gate resistance and a turn-on gate resistance of the switching transistor, a bus voltage, and a minimum turn-on voltage and a maximum bearable negative voltage absolute value of the switching transistor; and a second determining module configured to: input the turn-off gate resistance, the turn-on gate resistance, the bus voltage, and the minimum turn-on voltage into the first turn-off negative voltage model to obtain a turn-off negative voltage upper limit absolute value of the switching transistor; input the turn-off gate resistance, the turn-on gate resistance, the bus voltage, and the maximum bearable negative voltage absolute value into the second turn-off negative voltage model to obtain a turn-off negative voltage lower limit absolute value of the switching transistor; and determine a turn-off negative voltage interval of the switching transistor based on the turn-off negative voltage upper limit absolute value and the turn-off negative voltage lower limit absolute value.

In the apparatus for determining the turn-off negative voltage of the switching transistor according to the embodiments of the present disclosure, the turn-off negative voltage upper limit absolute value of the switching transistor is obtained by inputting the acquired turn-off gate resistance, turn-on gate resistance, bus voltage, and minimum turn-on voltage of the switching transistor into the first turn-off negative voltage model, and the turn-off negative voltage lower limit absolute value of the switching transistor is obtained by inputting the acquired turn-off gate resistance, turn-on gate resistance, bus voltage, and maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when the negative voltage turn-off control is performed on the switching transistor by using the turn-off negative voltage interval, the switching transistor can be effectively prevented from being turned on mistakenly, and the switching transistor can be protected, which can prolong service life of the switching transistor.

The present invention further provides an inverter. The inverter comprises a memory, a processor, and a program for determining a turn-off negative voltage of a switching transistor stored on the memory and executable on the processor. The processor is configured to implement, when executing the program for determining the turn-off negative voltage of the switching transistor, the method for determining the turn-off negative voltage of the switching transistor according to any one of the above-mentioned embodiments.

In the inverter of the embodiments according to the present disclosure, the turn-off negative voltage upper limit absolute value of the switching transistor is obtained by inputting the acquired turn-off gate resistance, turn-on gate resistance, bus voltage, and minimum turn-on voltage of the switching transistor into the first turn-off negative voltage model, and the turn-off negative voltage lower limit absolute value of the switching transistor is obtained by inputting the acquired turn-off gate resistance, turn-on gate resistance, bus voltage, and maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when the negative voltage turn-off control is performed on the switching transistor by using the turn-off negative voltage interval, the switching transistor can be effectively prevented from being turned on mistakenly, and the switching transistor can be protected, which can prolong service life of the switching transistor.

The present invention further provides a computer-readable storage medium, having a program for determining a turn-off negative voltage of a switching transistor stored thereon. The program for determining the turn-off negative voltage of the switching transistor, when executed by a processor, implements the method for determining the turn-off negative voltage of the switching transistor according to any one of the above-mentioned embodiments.

In the computer-readable storage medium according to the embodiments of the present disclosure, the turn-off negative voltage upper limit absolute value of the switching transistor is obtained by inputting the acquired turn-off gate resistance, turn-on gate resistance, bus voltage, and minimum turn-on voltage of the switching transistor into the first turn-off negative voltage model, and the turn-off negative voltage lower limit absolute value of the switching transistor is obtained by inputting the acquired turn-off gate resistance, turn-on gate resistance, bus voltage, and maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when the negative voltage turn-off control is performed on the switching transistor by using the turn-off negative voltage interval, the switching transistor can be effectively prevented from being turned on mistakenly, and the switching transistor can be protected, which can prolong service life of the switching transistor.

The present invention further provides a switching transistor drive control circuit. The switching transistor drive control circuit comprises a drive power supply, a drive unit, and a control unit. The control unit is configured to acquire a turn-off negative voltage interval of a switching transistor by implementing the method for determining the turn-off negative voltage of the switching transistor according to any one of the above-mentioned embodiments, and control the drive power supply based on the turn-off negative voltage interval to provide a negative turn-off voltage to the drive unit. The drive unit is configured to drive, in response to receiving a turn-off control signal, the switching transistor to be turned off based on the negative turn-off voltage.

In the switching transistor drive control circuit according to the embodiments of the present disclosure, the turn-off negative voltage upper limit absolute value of the switching transistor is obtained by inputting the acquired turn-off gate resistance, turn-on gate resistance, bus voltage, and minimum turn-on voltage of the switching transistor into the first turn-off negative voltage model, and the turn-off negative voltage lower limit absolute value of the switching transistor is obtained by inputting the acquired turn-off gate resistance, turn-on gate resistance, bus voltage, and maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when the negative voltage turn-off control is performed on the switching transistor by using the turn-off negative voltage interval, the switching transistor can be effectively prevented from being turned on mistakenly, and the switching transistor can be protected, which can prolong service life of the switching transistor.

In some embodiments of the present disclosure, the drive unit comprises a drive chip and a first gate resistor. The drive chip has a positive power pin connected to a positive turn-on voltage supply terminal of the drive power supply, a negative power pin connected to a negative turn-off voltage supply terminal of the drive power supply, and an input pin connected to the control unit to receive the turn-off control signal sent by the control unit. The first gate resistor has a terminal connected to an output pin of the drive chip and another terminal connected to a gate of the switching transistor.

In some embodiments of the present disclosure, the drive unit further comprises a first diode and a second gate resistor. The first diode has a cathode connected to a terminal of the first gate resistor. The second gate resistor has a terminal connected to an anode of the first diode and another terminal connected to the other terminal of the first gate resistor.

In some embodiments of the present disclosure, the drive unit further comprises a second diode. The second diode has a cathode connected to the terminal of the first gate resistor and an anode connected to the cathode of the first diode.

In some embodiments of the present disclosure, the drive unit further comprises a first diode and a second gate resistor. The first diode has a cathode connected to the terminal of the first gate resistor and an anode connected to the other terminal of the first gate resistor. The second gate resistor has a terminal connected to an anode of the first diode, and another terminal connected to the gate of the switching transistor.

In some embodiments of the present disclosure, the drive unit further comprises a first coupling capacitor and a second coupling capacitor. The first coupling capacitor has a terminal connected to a positive turn-on voltage supply terminal of the drive power supply. The second coupling capacitor has a terminal connected to another terminal of the first coupling capacitor, and another terminal connected to a negative turn-off voltage supply terminal of the drive power supply.

In some embodiments of the present disclosure, when the switching transistor is an upper bridge switching transistor, a node between the first coupling capacitor and the second coupling capacitor is connected to a midpoint of a bridge arm at which the upper bridge switching transistor is located. When the switching transistor is a lower bridge switching transistor, the node between the first coupling capacitor and the second coupling capacitor is grounded.

The present invention further provides a motor control system. The motor control system comprises the switching transistor drive control circuit according to any one of the above-mentioned embodiments.

In the motor control system according to the embodiments of the present disclosure, the turn-off negative voltage upper limit absolute value of the switching transistor is obtained by inputting the acquired turn-off gate resistance, turn-on gate resistance, bus voltage, and minimum turn-on voltage of the switching transistor into the first turn-off negative voltage model, and the turn-off negative voltage lower limit absolute value of the switching transistor is obtained by inputting the acquired turn-off gate resistance, turn-on gate resistance, bus voltage, and maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when the negative voltage turn-off control is performed on the switching transistor by using the turn-off negative voltage interval, the switching transistor can be effectively prevented from being turned on mistakenly, and the switching transistor can be protected, which can prolong service life of the switching transistor.

The present invention further provides a compressor. The compressor comprises the motor control system according to any one of the above-mentioned embodiments.

In the compressor according to the embodiments of the present disclosure, the turn-off negative voltage upper limit absolute value of the switching transistor is obtained by inputting the acquired turn-off gate resistance, turn-on gate resistance, bus voltage, and minimum turn-on voltage of the switching transistor into the first turn-off negative voltage model, and the turn-off negative voltage lower limit absolute value of the switching transistor is obtained by inputting the acquired turn-off gate resistance, turn-on gate resistance, bus voltage, and maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when the negative voltage turn-off control is performed on the switching transistor by using the turn-off negative voltage interval, the switching transistor can be effectively prevented from being turned on mistakenly, and the switching transistor can be protected, which can prolong service life of the switching transistor.

The present invention further provides a vehicle. The vehicle comprises the compressor according to any one of the above-mentioned embodiments.

In the vehicle according to the embodiments of the present disclosure, the turn-off negative voltage upper limit absolute value of the switching transistor is obtained by inputting the acquired turn-off gate resistance, turn-on gate resistance, bus voltage, and minimum turn-on voltage of the switching transistor into the first turn-off negative voltage model, and the turn-off negative voltage lower limit absolute value of the switching transistor is obtained by inputting the acquired turn-off gate resistance, turn-on gate resistance, bus voltage, and maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when the negative voltage turn-off control is performed on the switching transistor by using the turn-off negative voltage interval, the switching transistor can be effectively prevented from being turned on mistakenly, and the switching transistor can be protected, which can prolong service life of the switching transistor.

Additional aspects and advantages of the embodiments of the present disclosure will be given at least in part in the following description, or become apparent at least in part from the following description, or can be learned from practicing of the embodiments of the present disclosure.

**BRIEF DESCRIPTION OF THE DRAWINGS**

The above and/or additional aspects and advantages of the present disclosure will become more apparent and more understandable from the following description of embodiments taken in conjunction with the accompanying drawings.

FIG. 1 is a schematic flowchart showing a method for determining a turn-off negative voltage of a switching transistor according to an embodiment of the present disclosure.

FIG. 2 is a schematic scene graph showing a method for determining a turn-off negative voltage of a switching transistor according to an embodiment of the present disclosure.

FIG. 3 is a schematic scene graph showing a method for determining a turn-off negative voltage of a switching transistor according to another embodiment of the present disclosure.

FIG. 4 is a schematic flowchart showing a method for determining a turn-off negative voltage of a switching transistor according to another embodiment of the present disclosure.

FIG. 5 is a structural block diagram showing an apparatus for determining a turn-off negative voltage of a switching transistor according to an embodiment of the present disclosure.

FIG. 6 is a structural block diagram showing an inverter according to an embodiment of the present disclosure.

FIG. 7 is a structural block diagram showing a switching transistor drive control circuit according to an embodiment of the present disclosure.

FIG. 8 is a schematic circuit view showing a switching transistor drive control circuit according to an embodiment of the present disclosure.

FIG. 9 is a schematic circuit view showing a switching transistor drive control circuit according to another embodiment of the present disclosure.

FIG. 10 is a schematic circuit view showing a switching transistor drive control circuit according to another embodiment of the present disclosure.

FIG. 11 is a schematic circuit view showing a switching transistor drive control circuit according to another embodiment of the present disclosure.

FIG. 12 is a structural block diagram showing a motor control system according to an embodiment of the present disclosure.

FIG. 13 is a structural block diagram showing a compressor according to an embodiment of the present disclosure.

FIG. 14 is a structural block diagram showing a vehicle according to an embodiment of the present disclosure.

## DETAILED DESCRIPTION OF THE EMBODIMENTS

Embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain, rather than limiting, the present disclosure.

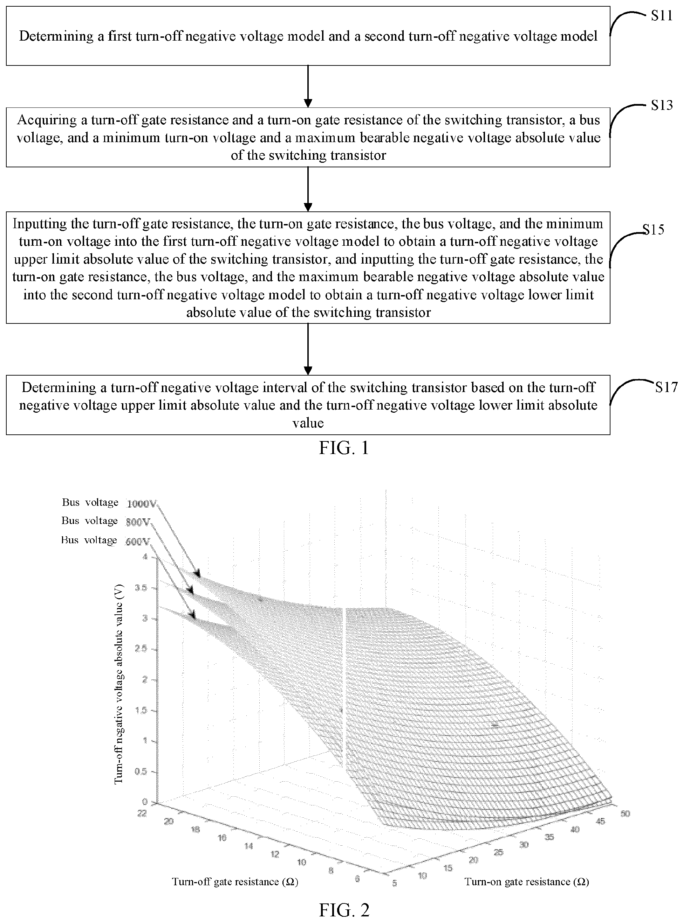

In order to clearly explain a method and apparatus for determining a turn-off negative voltage of a switching transistor, and a switching transistor drive control circuit according to the embodiments of the present disclosure, a description will be made in conjunction with a schematic flowchart of a method for determining a turn-off negative voltage of a switching transistor shown in FIG. 1. As shown in FIG. 1, the method for determining the turn-off negative voltage of the switching transistor according to the embodiments of the present disclosure comprises operations at blocks S11 to S17.

At block S11, a first turn-off negative voltage model and a second turn-off negative voltage model are determined.

At block S13, a turn-off gate resistance and a turn-on gate resistance of the switching transistor, a bus voltage, and a minimum turn-on voltage and a maximum bearable negative voltage absolute value of the switching transistor are acquired.

At block S15, the turn-off gate resistance, the turn-on gate resistance, the bus voltage, and the minimum turn-on voltage are inputted into the first turn-off negative voltage model to obtain a turn-off negative voltage upper limit absolute value of the switching transistor, and the turn-off gate resistance, the turn-on gate resistance, the bus voltage, and the maximum bearable negative voltage absolute value are inputted into the second turn-off negative voltage model to obtain a turn-off negative voltage lower limit absolute value of the switching transistor.

At block S17, a turn-off negative voltage interval of the switching transistor is determined based on the turn-off negative voltage upper limit absolute value and the turn-off negative voltage lower limit absolute value.

In the method for determining the turn-off negative voltage of the switching transistor according to the embodiments of the present disclosure, the turn-off negative voltage upper limit absolute value of the switching transistor is obtained by inputting the acquired turn-off gate resistance, turn-on gate resistance, bus voltage, and minimum turn-on voltage of the switching transistor into the first turn-off negative voltage model, and the turn-off negative voltage lower limit absolute value of the switching transistor is obtained by inputting the acquired turn-off gate resistance, turn-on gate resistance, bus voltage, and maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when a negative voltage turn-off control is performed on the switching transistor by using the turn-off negative voltage interval, the switching transistor can be effectively prevented from being turned on mistakenly, and the switching transistor can be protected, which can prolong service life of the switching transistor.

It may be understood that although the method of applying the turn-off negative voltage to the gate can prevent the switching transistor from being turned on mistakenly, in a case where the turn-off negative voltage upper limit absolute value is set too low, the switching transistor may still be turned on mistakenly in some cases, and in a case where the turn-off negative voltage lower limit absolute value is set too high, a negative voltage spike value may exceed an allowable driving negative voltage lower limit absolute value of the switching transistor, reducing life of the switching transistor and even causing damage to the switch. Therefore, the turn-off negative voltage interval of the switching transistor needs to be accurately determined.

In an exemplary embodiment of the present disclosure, the first turn-off negative voltage model can determine the turn-off negative voltage upper limit absolute value of the switching transistor. An expression form of the first turn-off negative voltage model comprises, but is not limited to, a neural network model, a data mapping graph/table, a mathematical relational expression, and the like. When the first turn-off negative voltage model is the neural network model, inputs of the neural network model may comprise the turn-off gate resistance, the turn-on gate resistance, the bus voltage, and the minimum turn-on voltage of the switching transistor, and outputs of the neural network model may comprise the turn-off negative voltage upper limit absolute value of the switching transistor. As a result, after the turn-off gate resistance, the turn-on gate resistance, the bus voltage, and the minimum turn-on voltage of the switching transistor are acquired, the turn-off gate resistance, the turn-on gate resistance, the bus voltage, and the minimum turn-on voltage are inputted into the neural network model, to quickly obtain corresponding relatively accurate turn-off negative voltage upper limit absolute value of the switching transistor. When the first turn-off negative voltage model is the data mapping graph/table, the data mapping graph/table may comprise predetermined turn-off gate resistances, turn-on gate resistances, and bus voltages of different switching transistors, and turn-off negative voltage upper limit absolute values corresponding to minimum turn-on voltages of the different transistors. As a result, after the turn-off gate resistance, the turn-on gate resistance, the bus voltage, and the minimum turn-on voltage of the switching transistor are acquired, corresponding relatively accurate turn-off negative voltage upper limit absolute value of the switching transistor can be quickly obtained by finding the data mapping map/table. When the first turn-off negative voltage model is the mathematical relational expression, the mathematical relational expression can reflect a relationship between the turn-off gate resistance, the turn-on gate resistance, the bus voltage, and the minimum turn-on voltage of the switching transistor and the turn-off negative voltage upper limit absolute value of the switching transistor. As a result, after the turn-off gate resistance, the turn-on gate resistance, the bus voltage, and the minimum turn-on voltage of the switching transistor are acquired, the corresponding turn-off negative voltage upper limit absolute value of the switching transistor can be obtained from the mathematical relationship expression.

The second turn-off negative voltage model can determine the turn-off negative voltage lower limit absolute value of the switching transistor. An expression form of the second turn-off negative voltage model comprises, but is not limited to, a neural network model, a data mapping graph/table, a mathematical relational expression, and the like. When the second turn-off negative voltage model is the neural network model, inputs of the neural network model may comprise the turn-off gate resistance, the turn-on gate resistance, the bus voltage, and the maximum bearable negative voltage absolute value of the switching transistor, and outputs of the neural network model may comprise the turn-off negative voltage lower limit absolute value of the switching transistor. As a result, after the turn-off gate resistance, the turn-on gate resistance, the bus voltage, and the maximum bearable negative voltage absolute value of the switching transistor are acquired, the turn-off gate resistance, the turn-on gate resistance, the bus voltage, and the maximum bearable negative voltage absolute value are inputted into the neural network model, to quickly obtain corresponding relatively accurate turn-off negative voltage lower limit absolute value of the switching transistor. When the second turn-off negative voltage model is the data mapping graph/table, the data mapping graph/table may comprise predetermined turn-off gate resistances, turn-on gate resistances, and bus voltages of different switching transistors, and turn-off negative voltage lower limit absolute values corresponding to maximum bearable negative voltage absolute values of the different switching transistors. As a result, after the turn-off gate resistance, the turn-on gate resistance, the bus voltage, and the maximum bearable negative voltage absolute value of the switching transistor are acquired, corresponding relatively accurate turn-off negative voltage lower limit absolute value of the switching transistor can be quickly obtained by finding the data mapping map/table. When the second turn-off negative voltage model is the mathematical relational expression, the mathematical relational expression can reflect a relationship between the turn-off gate resistance, the turn-on gate resistance, the bus voltage, and the maximum bearable negative voltage absolute value of the switching transistor and the turn-off negative voltage lower limit absolute value of the switching transistor. As a result, after the turn-off gate resistance, the turn-on gate resistance, the bus voltage, and the maximum bearable negative voltage absolute value of the switching transistor are acquired, the corresponding turn-off negative voltage lower limit absolute value of the switching transistor can be obtained from the mathematical relationship expression.

In some embodiments, the first turn-off negative voltage model and the corresponding second turn-off negative voltage model may be determined based on a model of the switching transistor, respectively. The first turn-off negative voltage model of the switching transistors of indifferent models may have the same or different expression forms, and the second turn-off negative voltage model of the switching transistors of different models may have the same or different expression forms, which are not limited herein. In some embodiments, the first turn-off negative voltage model and the second turn-off negative voltage model of the switching transistor of a same model have a same form.

It should be noted that the turn-off negative voltage is negative, and the turn-off negative voltage interval may be understood as a value interval of the turn-off negative voltage. That is, all of numerical values in the turn-off negative voltage interval are negative.

In some embodiments of the present disclosure, the first turn-off negative voltage model is expressed as: $V_{SS\_min}=\lambda_1*f_1(R_{G\_on}, R_{G\_off}, V_{DC})-V_{th}$, i.e. equation (1), where $V_{SS\_min}$ represents the turn-off negative voltage upper limit absolute value, $\lambda_1$ represents a first derating parameter, $f_1(R_{G\_on}, R_{G\_off}, V_{DC})$ represents a function expression corresponding to the first turn-off negative voltage model, $R_{G\_on}$ represents the turn-on gate resistance, $R_{G\_off}$ represents the turn-off gate resistance, $V_{DC}$ represents the bus voltage, and $V_{th}$ represents the minimum turn-on voltage.

In this way, a relationship between the turn-on gate resistance and the turn-on gate resistance of the switching transistor, the bus voltage, and the minimum turn-on voltage of the switching transistor and the turn-off negative voltage upper limit absolute value of the switching transistor can be clearly expressed by the above equation (1).

In an exemplary embodiment of the present disclosure, the turn-off gate resistance may be understood as a total resistance of a turn-off circuit when the switching transistor is turned off, and the turn-on gate resistance may be understood as a total resistance of a turn-on circuit when the switching transistor is turned on. In some embodiments, the minimum turn-on voltage may be obtained by querying corresponding data based on a specific model of the switching transistor. In some embodiments, the first derating parameter may be obtained by querying corresponding derating criteria based on a specific model of the resistor. In some embodiments, the bus voltage may be obtained by a bus voltage measurement device.

In some embodiments, a relationship between the turn-off negative voltage upper limit absolute value and the turn-on gate resistance, the turn-off gate resistance, and the bus voltage is shown in FIG. 2. It should be understood that when the turn-on gate resistance, the turn-off gate resistance, and the bus voltage input into the first turn-off negative voltage model change, the turn-off negative voltage upper limit absolute value output from the first turn-off negative voltage model will also change accordingly. Further, different turn-on gate resistances, different turn-off gate resistances, different bus voltages, and corresponding turn-off negative voltage upper limit absolute values, which are obtained through extensive simulation experiments, are substituted into the above equation (1) to obtain multiple different polynomials. After polynomial fitting, a specific expression of the first turn-off negative voltage model can be expressed as $V_{SS\_min}=b_2*R_{G\_on}+b_3*R_{G\_off}+b_4*V_{DC}+b_5*R_{G\_on}^2+b_6*R_{G\_off}^2+b_7*V_{DC}^2+b_8*R_{G\_on}*R_{G\_off}+b_9*R_{G\_off}*V_{DC}+b_{10}*R_{G\_off}*V_{DC}-V_{th}$, i.e. equation (2), where $b_2=-24.41$, $b_3=63.47$, $b_4=222.4$, $b_5=0.555$, $b_6=1.033$, $b_7=-8.683$, $b_8=-1.096$, $b_9=6.276$, and $b_{10}=-2.759$.

In an example, the minimum turn-on voltage of the switching transistor is 1.5 V, and the bus voltage is 900 V. The selected turn-on gate resistance is 40 $\Omega$, and the selected turn-off gate resistance is 20 $\Omega$. By using the equation (2), it is obtained that the turn-off negative voltage upper limit absolute value is 2.44 V. That is, the turn-off negative voltage of the switching transistor should be smaller than -2.44 V.

In some embodiments of the present disclosure, the second turn-off negative voltage model is expressed as $V_{SS\_max}=V_{GS\_max}-\lambda_2*f_2(R_{G\_on}, R_{G\_off}, V_{DC})$, i.e. equation (3), where $V_{SS\_max}$ is the turn-off negative voltage lower limit absolute value, $\lambda_2$ is a second derating parameter, $f_2(R_{G\_on}, R_{G\_off}, V_{DC})$ is a function expression corresponding to the second turn-off negative voltage model, $R_{G\_on}$ is the turn-on gate resistance, $R_{G\_off}$ is the turn-off gate resistance, $V_{DC}$ is the bus voltage, and $V_{GS\_max}$ is the maximum bearable negative voltage absolute value.

Thus, a relationship between the turn-off gate resistance, the turn-on gate resistance, the bus voltage, and the maximum bearable negative voltage absolute value of the switching transistor and the turn-off negative voltage lower limit absolute value of the switching transistor can be clearly expressed by the above equation (3).

In an exemplary embodiment of the present disclosure, the turn-off gate resistance may be understood as the total resistance of the turn-off circuit when the switching transistor is turned off, and the turn-on gate resistance may be understood as the total resistance of the turn-on circuit when the switching transistor is turned on. In some embodiments, the maximum bearable negative voltage absolute value may be obtained by querying corresponding data based on a specific model of the switching transistor. In some embodiments, the second derating parameter may be obtained by querying corresponding derating criteria based on a specific model of the resistor. In some embodiments, the bus voltage may be obtained by the bus voltage measurement device.

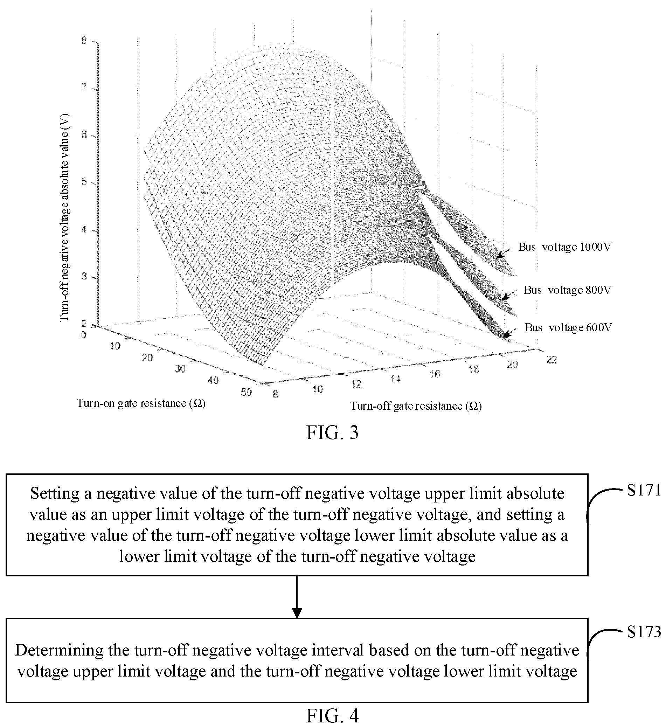

In some embodiments, a relationship between the turn-off negative voltage lower limit absolute value and the turn-on gate resistance, the turn-off gate resistance, and the bus voltage is shown in FIG. 3. It should be understood that when the turn-on gate resistance, the turn-off gate resistance, and the bus voltage input by the second turn-off negative voltage model change, the turn-off negative voltage lower limit absolute value output from the second turn-off negative voltage model will also change accordingly. Further, different turn-on gate resistances, different turn-off gate resistances, different bus voltages, and corresponding turn-off negative voltage upper lower absolute values are substituted into the above equation (3) to obtain multiple different polynomials. After polynomial fitting, a specific expression of the second turn-off negative voltage model may be expressed as $V_{SS\_max}=V_{GS\_max}+d_2*R_{G\_on}+d_3*R_{G\_off}+d_4*V_{DC}+d_5*R_{G\_on}^2+d_6*R_{G\_off}^2+d_7*V_{DC}^2+d_8*R_{G\_on}*R_{G\_off}+d_9*R_{G\_off}*V_{DC}+d_{10}*R_{G\_off}*V_{DC}$, i.e. equation (4), where $d_2=-122.9$, $d_3=1454.0$, $d_4=-488.3$, $d_5=2.069$, $d_6=-47.87$, $d_7=15.43$, $d_8=-0.805$, $d_9=3.800$, and $d_{10}=-5.223$.

In an example, the maximum bearable negative voltage of the switching transistor is -9V. That is, the switching transistor maximum bearable negative voltage absolute value is 9V. The bus voltage is 900 V, the selected turn-on gate resistance is 40 Ω, and the selected turn-off gate resistance is 20 Ω. By using the equation (4), it is obtained that the turn-off negative voltage lower limit absolute value is 4.96 V. That is, the turn-off negative voltage of the switching transistor should be greater than -4.96 V.

Referring to FIG. 4, in some embodiments of the present disclosure, the operation at block S17 further comprises operations at blocks S171 and S173.

At block S171, a negative value of the turn-off negative voltage upper limit absolute value is set as a turn-off negative voltage upper limit voltage, and a negative value of the turn-off negative voltage lower limit absolute value is set as a lower limit voltage of the turn-off negative voltage.

At block S173, the turn-off negative voltage interval is determined based on the upper limit voltage of the turn-off negative voltage and the lower limit voltage of the turn-off negative voltage.

In this way, the turn-off negative voltage interval of the switching transistor can be accurately obtained. When a voltage of the gate of the switching transistor is within the turn-off negative voltage interval, the switching transistor can be turned off, effectively preventing the switching transistor from being turned on mistakenly.

In an exemplary embodiment of the present disclosure, the turn-off negative voltage upper limit absolute value may be understood as an upper limit of an absolute value of the turn-off negative voltage, and the turn-off negative voltage lower limit absolute value may be understood as a lower limit of an absolute value of the turn-off negative voltage. That is, both the turn-off negative voltage upper limit absolute value and the turn-off negative voltage lower limit absolute value are positive, and the turn-off negative voltage of the switching transistor is negative. Therefore, a negative value of the turn-off negative voltage upper limit absolute value is set as the upper limit voltage of the turn-off negative voltage, and a negative value of the turn-off negative voltage lower limit absolute value is set as the lower limit voltage of the turn-off negative voltage, and then the turn-off negative voltage interval is determined based on the lower limit voltage of the turn-off negative voltage and the upper limit voltage of the turn-off negative voltage. In this way, it can be ensured that the turn-off negative voltage of the selected switching transistor is greater than or equal to the lower limit voltage of the turn-off negative voltage, and the turn-off negative voltage of the switching transistor is smaller than or equal to the upper limit voltage of the turn-off negative voltage.

In an example, the minimum turn-on voltage of the switching transistor may be 1.5 V, and the maximum bearable negative voltage of the switching transistor is -9 V. That is, the maximum bearable negative voltage absolute value of the switching transistor is 9 V. The bus voltage may be 900 V. The selected turn-on gate resistance is 40 Ω, and the selected turn-off gate resistance is 20 Ω. By using the equation (2), it is obtained that the turn-off negative voltage upper limit absolute value is 2.44 V. That is, the upper limit voltage of the turn-off negative voltage of the switching transistor is -2.44 V. By using the equation (4), it is obtained that the turn-off negative voltage lower limit absolute value of the switching transistor is 4.96 V. That is, the lower limit voltage of the turn-off negative voltage of the switching transistor is -4.96 V. Thus, the turn-off negative voltage interval of the switching transistor can be determined as [-4.96 V, -2.44V].

In some embodiments of the present disclosure, the switching transistor is a silicon-carbide Metal Oxide Semiconductor (MOS) transistor.

Therefore, the turn-off negative voltage interval can be accurately determined based on the above method, thereby effectively preventing the silicon carbide MOS transistor from being turned on mistakenly, protecting the silicon carbide MOS transistor, and prolonging the service life of the silicon carbide MOS transistor. It should be understood that the silicon carbide MOS transistor is more likely to be turned on mistakenly due to its fast speed and a low minimum turn-on voltage.

It should be noted that the specific numerical values mentioned above are only for the purpose of illustrating the embodiments of the present disclosure in detail by way of example, and should not be construed as limitations on the present disclosure. In other examples or embodiments, other numerical values may be selected in accordance with the present disclosure, and the present disclosure is not limited in this regard.

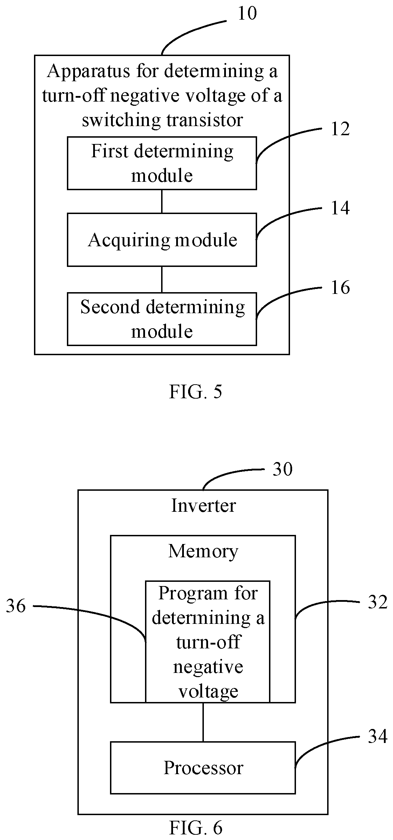

In order to implement the above embodiments, embodiments of the present disclosure further provide an apparatus for determining a turn-off negative voltage of a switching transistor. The apparatus can implement the method for determining the turn-off negative voltage of the switching transistor according to any of the above embodiments. FIG. 5 is a block diagram of an apparatus for determining a turn-off negative voltage of a switching transistor according to an embodiment of the present disclosure. As shown in FIG. 5, an apparatus 10 for determining a turn-off negative voltage of a switching transistor according to an embodiment of the present disclosure comprises a first determining module 12, an acquiring module 14, and a second determining module 16. The first determining module 12 is configured to determine a first turn-off negative voltage model and a second turn-off negative voltage model. The acquiring module 14 is configured to acquire a turn-off gate resistance and a turn-on gate resistance of the switching transistor, a bus voltage, and a minimum turn-on voltage and a maximum bearable negative voltage absolute value of the switching transistor. The second determining module 16 is configured to: input the turn-off gate resistance, the turn-on gate resistance, the bus voltage, and the minimum turn-on voltage into the first turn-off negative voltage model to obtain a turn-off negative voltage upper limit absolute value of the switching transistor; input the turn-off gate resistance, the turn-on gate resistance, the bus voltage, and the maximum bearable negative voltage absolute value into the second turn-off negative voltage model to obtain a turn-off negative voltage lower limit absolute value of the switching transistor; and determine a turn-off negative voltage interval of the switching transistor based on the turn-off negative voltage upper limit absolute value and the turn-off negative voltage lower limit absolute value.

In the apparatus 10 for determining the turn-off negative voltage of the switching transistor according to the embodiments of the present disclosure, the turn-off negative voltage upper limit absolute value of the switching transistor is obtained by inputting the acquired turn-off gate resistance, turn-on gate resistance, bus voltage, and minimum turn-on voltage of the switching transistor into the first turn-off negative voltage model, and the turn-off negative voltage lower limit absolute value of the switching transistor is obtained by inputting the acquired turn-off gate resistance, turn-on gate resistance, bus voltage, and maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when a negative voltage turn-off control is performed on the switching transistor by using the turn-off negative voltage interval, the switching transistor can be effectively prevented from being turned on mistakenly, and the switching transistor can be protected, which can prolong service life of the switching transistor.

In some embodiments of the present disclosure, the first turn-off negative voltage model is expressed as $V_{SS\_min}=\lambda_1*f_1(R_{G\_on}, R_{G\_off}, V_{DC})-V_{th}$, i.e. equation (1), where $V_{SS\_min}$ represents the turn-off negative voltage upper limit absolute value, $\lambda_1$ represents a first derating parameter, $f_1(R_{G\_on}, R_{G\_off}, V_{DC})$ represents a function expression corresponding to the first turn-off negative voltage model, $R_{G\_on}$ represents the turn-on gate resistance, $R_{G\_off}$ represents the turn-off gate resistance, $V_{DC}$ represents the bus voltage, and $V_{th}$ is the minimum turn-on voltage.

In some embodiments of the present disclosure, the second turn-off negative voltage model is expressed as $V_{SS\_max}=V_{GS\_max}-\lambda_2*f_2(R_{G\_on}, R_{G\_off}, V_{DC})$, i.e. equation (3), where $V_{SS\_max}$ represents the turn-off negative voltage lower limit absolute value, $\lambda_2$ represents a second derating parameter, $f_2(R_{G\_on}, R_{G\_off}, V_{DC})$ represents a function expression corresponding to the second turn-off negative voltage model, $R_{G\_on}$ represents the turn-on gate resistance, $R_{G\_off}$ represents the turn-off gate resistance, $V_{DC}$ represents the bus voltage, and $V_{GS\_max}$ represents the maximum bearable negative voltage absolute value.

In some embodiments of the present disclosure, the second determination module 16 comprises a first determination unit and a second determination unit. The first determination unit is configured to set a negative value of the turn-off negative voltage upper limit absolute value as a turn-off negative voltage upper limit voltage, and set a negative value of the turn-off negative voltage lower limit absolute value as a lower limit voltage of the turn-off negative voltage. The second determination unit is configured to determine the turn-off negative voltage interval based on the lower limit voltage of the turn-off negative voltage and the upper limit voltage of the turn-off negative voltage.

In some embodiments of the present disclosure, the switching transistor is the silicon-carbide MOS transistor.

It should be noted that the explanatory description of the embodiments and beneficial effects of the method for determining the turn-off negative voltage of the switching transistor is also adapted to the apparatus 10 for determining the turn-off negative voltage of the switching transistor of the present disclosure, and thus the detailed description thereof will be omitted herein to avoid redundancy.

In order to implement the above embodiments, embodiments of the present disclosure further provide an inverter, which can implement the method for determining the turn-off negative voltage of the switching transistor according to any one of the above embodiments. FIG. 6 is a block diagram of an inverter according to an embodiment of the present disclosure. As shown in FIG. 6, an inverter 30 comprises a memory 32, a processor 34, and a program 36 for determining a turn-off negative voltage of a switching transistor stored in the memory 32 and executable on the processor 34. The processor 34 is configured to implement, when executing the program 36 for determining the turn-off negative voltage of the switching transistor, the method for determining the turn-off negative voltage of the switching transistor according to any one of the embodiments described above.

In the inverter 30 according to the embodiments of the present disclosure, the turn-off negative voltage upper limit absolute value of the switching transistor is obtained by inputting the acquired turn-off gate resistance, turn-on gate resistance, bus voltage, and minimum turn-on voltage of the switching transistor into the first turn-off negative voltage model, and the turn-off negative voltage lower limit absolute value of the switching transistor is obtained by inputting the acquired turn-off gate resistance, turn-on gate resistance, bus voltage, and maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when a negative voltage turn-off control is performed on the switching transistor by using the turn-off negative voltage interval, the switching transistor can be effectively prevented from being turned on mistakenly, and the switching transistor can be protected, which can prolong service life of the switching transistor.

For example, the processor 34 is configured to implement, when the program 36 for determining the turn-off negative voltage of the switching transistor is executed by processor 34, operations at blocks at S11 to S17 of the method for determining the turn-off negative voltage of the switching transistor.

At block S11, a first turn-off negative voltage model and a second turn-off negative voltage model are determined.

At block S13, a turn-off gate resistance and a turn-on gate resistance of the switching transistor, a bus voltage, and a minimum turn-on voltage and a maximum bearable negative voltage absolute value of the switching transistor are acquired.

At block S15, the turn-off gate resistance, the turn-on gate resistance, the bus voltage, and the minimum turn-on voltage are inputted into the first turn-off negative voltage model to obtain a turn-off negative voltage upper limit absolute value of the switching transistor, and the turn-off gate resistance, the turn-on gate resistance, the bus voltage, and the maximum bearable negative voltage absolute value are inputted into the second turn-off negative voltage model to obtain a turn-off negative voltage lower limit absolute value of the switching transistor.

At block S17, a turn-off negative voltage interval of the switching transistor is determined based on the turn-off negative voltage upper limit absolute value and the turn-off negative voltage lower limit absolute value.

It should be noted that the explanatory description of the embodiments and beneficial effects of the method for determining the turn-off negative voltage of the switching transistor is also adapted to the inverter 30 of the present disclosure, and thus the detailed description thereof will be omitted herein to avoid redundancy.

In order to implement the above embodiments, embodiments of the present disclosure further provide a computer-readable storage medium having a program for determining a turn-off negative voltage of a switching transistor stored thereon. The program for determining the turn-off negative voltage of the switching transistor, when executed by a processor, implements the method for determining the turn-off negative voltage of the switching transistor according to any one of the above embodiments.

In the computer-readable storage medium of the embodiments of the present disclosure, the turn-off negative voltage upper limit absolute value of the switching transistor is obtained by inputting the acquired turn-off gate resistance, turn-on gate resistance, bus voltage, and minimum turn-on voltage of the switching transistor into the first turn-off negative voltage model, and the turn-off negative voltage lower limit absolute value of the switching transistor is obtained by inputting the acquired turn-off gate resistance, turn-on gate resistance, bus voltage, and maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when a negative voltage turn-off control is performed on the switching transistor by using the turn-off negative voltage interval, the switching transistor can be effectively prevented from being turned on mistakenly, and the switching transistor can be protected, which can prolong service life of the switching transistor.

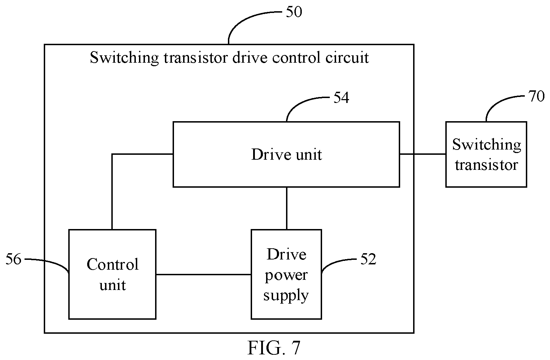

In order to implement the above embodiments, embodiments of the present disclosure further provide a switching transistor drive control circuit. FIG. 7 is a schematic circuit diagram of a switching transistor drive control circuit according to an embodiment of the present disclosure. As shown in FIG. 7, a switching transistor drive control circuit 50 comprises a drive power supply 52, a drive unit 54, and a control unit 56. The control unit 56 is configured to acquire a turn-off negative voltage interval of a switching transistor 70 by implementing the method for determining the turn-off negative voltage of the switching transistor 70 according to any one of the embodiments described above, and control the drive power supply 52 to provide a negative turn-off voltage to the drive unit 54 based on the turn-off negative voltage interval. The drive unit 54 is configured to drive, in response to receiving a turn-off control signal, the switching transistor 70 to be turned off based on the negative turn-off voltage.

In the switching transistor drive control circuit 50 according to the embodiments of the present disclosure, the turn-off negative voltage upper limit absolute value of the switching transistor 70 is obtained by inputting the acquired turn-off gate resistance, turn-on gate resistance, bus voltage, and minimum turn-on voltage of the switching transistor 70 into the first turn-off negative voltage model, and the turn-off negative voltage lower limit absolute value of the switching transistor 70 is obtained by inputting the acquired turn-off gate resistance, turn-on gate resistance, bus voltage, and maximum bearable negative voltage absolute value of the switching transistor 70 into the second turn-off negative voltage model. Then, the turn-off negative voltage interval of the switching transistor 70 is accurately determined based on the turn-off negative voltage upper limit absolute value of the switching transistor 70 and the turn-off negative voltage lower limit absolute value of the switching transistor 70. Therefore, when a negative voltage turn-off control is performed on the switching transistor 70 by using the turn-off negative voltage interval, the switching transistor 70 can be effectively prevented from being turned on mistakenly, and the switching transistor 70 can be protected, which can prolong service life of the switching transistor 70.

In some embodiments, the control unit 56 may be a Micro Control Unit (MCU).

In some embodiments of the present disclosure, the drive unit 54 comprises a first coupling capacitor and a second coupling capacitor. The first coupling capacitor has a terminal connected to a positive turn-on voltage supply terminal of the drive power supply. The second coupling capacitor has a terminal connected to another terminal of the first coupling capacitor, and another terminal connected to a negative turn-off voltage supply terminal of the drive power supply.

Thus, the positive turn-on voltage supply terminal and the negative turn-off voltage supply terminal of the drive power supply are isolated by the first coupling capacitor and the second coupling capacitor.

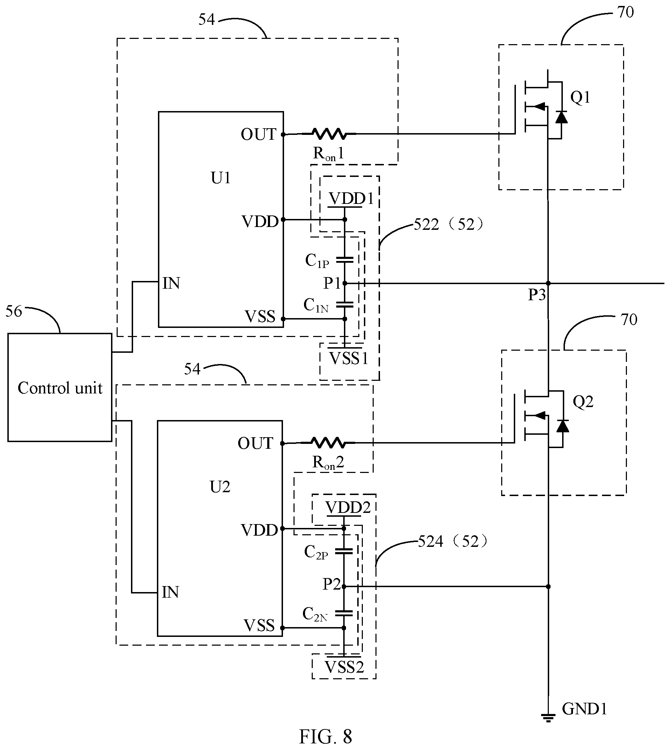

In an example, referring to FIG. 8, the first coupling capacitor comprises a capacitor $C_{1P}$ and a capacitor $C_{2P}$. The second coupling capacitor comprises a capacitor $C_{1N}$ and a capacitor $C_{2N}$. The drive power supply 52 comprises a first drive power supply 522 and a second drive power supply 524. The capacitor $C_{1P}$ has a terminal connected to a positive turn-on voltage supply terminal VDD1 of the first drive power supply 522. Another terminal of the capacitor $C_{1P}$ is connected to a terminal of the capacitor $C_{1N}$, and the capacitor $C_{1P}$ has a first node P1. The capacitor $C_{1N}$ has another terminal connected to a negative turn-off voltage supply terminal VSS1 of the first drive power supply 522. The capacitor $C_{2P}$ has a terminal connected to a positive turn-on voltage supply terminal VDD2 of the second drive power supply 524. Another terminal of is connected to a terminal of the capacitor $C_{2N}$, and the capacitor $C_{2P}$ has a second node P2. The capacitor $C_{2N}$ has another terminal connected to a negative turn-off voltage supply terminal VSS2 of the second drive power supply 524.

In some embodiments of the present disclosure, when the switching transistor 70 is an upper bridge switching transistor, a node between the first coupling capacitor and the second coupling capacitor is connected to a midpoint of a bridge arm at which the upper bridge switching transistor is located. When the switching transistor 70 is a lower bridge switching transistor, a node between the first coupling capacitor and the second coupling capacitor is grounded.

In this way, in a bridge inverter circuit, by using the switching transistor drive control circuit 50, the switching transistor can be accurately turned off, thereby effectively preventing the switching transistor 70 from being turned on mistakenly, protecting the switching transistor 70, and prolonging service life of the switching transistor 70. It should be understood that the bridge inverter circuit may comprise a single-phase full-bridge inverter circuit, a three-phase bridge inverter circuit, or bridge inverter circuits of other topologies.

In an example, referring to FIG. 8, the switching transistor 70 comprises an upper bridge switching transistor Q1 and a lower bridge switching transistor Q2. A source of the upper bridge switching transistor Q1 is connected to a drain of the lower bridge switching transistor Q2, and the upper bridge switching transistor Q1 has a third node P3. When the switching transistor 70 is the upper bridge switching transistor Q1, a first node P1 between the first coupling capacitor $C_{1P}$ and the second coupling capacitor $C_{1N}$ is connected to a midpoint (i.e. a third node P3) of the bridge arm at which the upper bridge switching transistor Q1 is located. When the switching transistor 70 is the lower bridge switching transistor Q2, a second node P2 between the first coupling capacitor $C_{2P}$ and the second coupling capacitor $C_{2N}$ is grounded.

In some embodiments of the present disclosure, the drive unit 54 comprises a drive chip and a first gate resistor. The drive chip has a positive power pin connected to the positive turn-on voltage supply terminal of the drive power supply, a negative power pin connected to the negative turn-off voltage supply terminal of the drive power supply, and an input pin connected to the control unit to receive a turn-off control signal sent by the control unit. The first gate resistor has a terminal connected to the output pin of the drive chip, and another terminal connected to a gate of the switching transistor.

In this way, the drive chip can drive the switching transistor to be turned on or off by the first gate resistor.

In an example, referring to FIG. 8, the drive chip comprises a chip U1 and a chip U2. The first gate resistor comprises a resistor $R_{on}1$ and a resistor $R_{on}2$. The drive power supply 52 comprises a first drive power supply 522 and a second drive power supply 524. The switching transistor 70 comprises an upper bridge switching transistor Q1 and a lower bridge switching transistor Q2. The first coupling capacitor comprises a capacitor $C_{1P}$ and a capacitor $C_{2P}$. The second coupling capacitor comprises a capacitor $C_{1N}$ and a capacitor $C_{2N}$.

The drive chip U1 has a positive power pin VDD connected to a positive turn-on voltage supply terminal VDD1 of the first drive power supply 522. The drive chip U1 has a negative power pin VSS connected to a negative turn-off voltage supply terminal VSS1 of the first drive power supply 522. The drive chip U1 has an input pin IN connected to a first terminal of the control unit 56 to receive a turn-off control signal sent by the control unit 56. The drive chip U1 has an output pin OUT connected to a terminal of the resistor $R_{on}1$. The resistor $R_{on}1$ has another terminal connected to a gate of the upper bridge switching transistor Q1. A source of the upper bridge switching transistor Q1 is connected to a drain of the lower bridge switching transistor Q2, and the upper bridge switching transistor Q1 has a third node P3. The capacitor $C_{1P}$ has a terminal connected to the positive turn-on voltage supply terminal VDD1 of the first drive power supply 522. Another terminal of the capacitor $C_{1P}$ is connected to a terminal of the capacitor $C_{1N}$, and the capacitor $C_{1P}$ has a first node P1. The first node P1 is connected to the third node P3. The capacitor $C_{1N}$ has another terminal connected to the negative turn-off voltage supply terminal VSS1 of the first drive power supply 522.

The drive chip U2 has a positive power pin VDD connected to a positive turn-on voltage supply terminal VDD2 of the second drive power supply 524. The drive chip U2 has a negative power pin VSS connected to a negative turn-off voltage supply terminal VSS2 of the second drive power supply 524. The drive chip U2 has an input pin IN connected to a second terminal of the control unit 56 to receive the turn-off control signal sent by the control unit 56. The drive chip U2 has an output pin OUT connected to a terminal of the resistor $R_{on}2$. The resistor $R_{on}2$ has another terminal connected to a gate of the lower bridge switching transistor Q2. A drain of the lower bridge switching transistor Q2 is connected to the source of the upper bridge switching transistor Q1, and a source of the lower bridge switching transistor Q2 is grounded. The capacitor $C_{2P}$ has a terminal connected to the positive turn-on voltage supply terminal VDD2 of the second drive power supply 524. Another terminal of the capacitor $C_{2P}$ is connected to a terminal of the capacitor $C_{2N}$, and the capacitor $C_{2P}$ has a second node P2. The second node P2 is grounded. The capacitor $C_{2N}$ has another terminal connected to the negative turn-off voltage supply terminal VSS2 of the second drive power supply 524.

When the control unit 56 sends the turn-on control signal through the first terminal, the positive power pin VDD of the drive chip U1 is in communication with the output pin OUT of the drive chip U1. The first drive power supply 522 provides a positive voltage to the positive power pin VDD of the drive chip U1, and the OUT pin of the drive chip U1 outputs the positive voltage. After voltage division by the resistor $R_{on}1$, a positive turn-on voltage is provided for the gate of the upper bridge switching transistor Q1, and the upper bridge switching transistor Q1 is turned on. It should be understood that the turn-on gate resistance is the resistor $R_{on}1$ in this case. When the control unit 56 sends a turn-off control signal through the first terminal, the negative power pin VSS of the drive chip U1 is in communication with the output pin OUT of the drive chip U1. The first drive power supply 522 provides a negative voltage to the negative power pin VSS of the drive chip U1, and the OUT pin of the drive chip U1 outputs the negative voltage. After voltage division by the resistor $R_{on}1$, a negative turn-off voltage is provided for the gate of the upper bridge switching transistor Q1, and the upper bridge switching transistor Q1 is turned off. It should be understood that the turn-off gate resistance is a resistance value of the resistor $R_{on}1$ in this case.

When the control unit 56 sends a turn-on control signal through the second terminal, the positive power pin VDD of the drive chip U2 is in communication with the output pin OUT of the drive chip U2. The second drive power supply 524 provides a positive voltage to the positive power pin VDD of the drive chip U2, and the OUT pin of the drive chip U2 outputs the positive voltage. After voltage division by the resistor $R_{on}2$, a positive turn-on voltage is provided for the gate of the lower bridge switching transistor Q2, and the lower bridge switching transistor Q2 is turned on. It should be understood that the turn-on gate resistance is the resistor $R_{on}2$ in this case. When the control unit 56 sends a turn-off control signal through the second terminal, the negative power pin VSS of the drive chip U2 is in communication with the output pin OUT of the drive chip U2. The second drive power supply 524 provides a negative voltage to the drive chip U2, and the OUT pin of the drive chip U2 outputs the negative voltage. After voltage division by the resistor $R_{on}2$, a negative turn-off voltage is provided for the gate of the lower bridge switching transistor Q2, and the lower bridge switching transistor Q2 is turned off. It should be understood that the turn-off gate resistance is a resistance value of the resistor $R_{on}2$ in this case.

In some embodiments of the present disclosure, the drive unit 54 further comprises a first diode and a second gate resistor. The first diode has a cathode connected to a terminal of the first gate resistor. The second gate resistor has a terminal connected to an anode of the first diode, and another terminal connected to the other terminal of the first gate resistor.

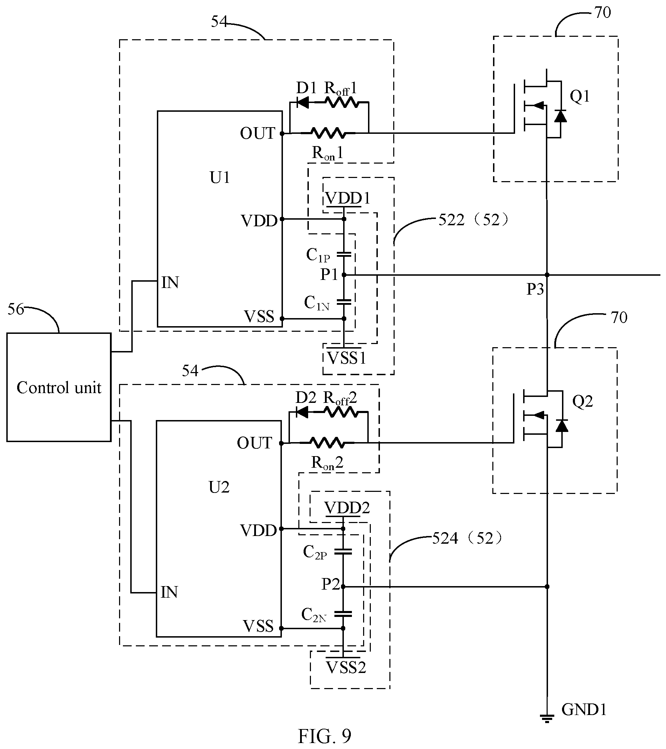

In an example, referring to FIG. 9, the drive chip comprises a chip U1 and a chip U2. The first gate resistor comprises a resistor $R_{on}1$ and a resistor $R_{on}2$. The second gate resistor comprises a resistor $R_{off}1$ and a resistor $R_{off}2$. The drive power supply 52 comprises a first drive power supply 522 and a second drive power supply 524. The switching transistor 70 comprises an upper bridge switching transistor Q1 and a lower bridge switching transistor Q2. The first coupling capacitor comprises a capacitor $C_{1P}$ and a capacitor $C_{2P}$. The second coupling capacitor comprises a capacitor $C_{1N}$ and a capacitor $C_{2N}$. The first diode comprises a diode D1 and a diode D2.

The drive chip U1 has a positive power pin VDD connected to a positive turn-on voltage supply terminal VDD1 of the first drive power supply 522. The drive chip U1 has a negative power pin VSS connected to a negative turn-off voltage supply terminal VSS1 of the first drive power supply 522. The drive chip U1 has an input pin IN connected to a first terminal of the control unit 56 to receive a turn-off control signal sent by the control unit 56. The drive chip U1 has an output pin OUT connected to a terminal of the resistor $R_{on}1$. The resistor $R_{on}1$ has another terminal connected to a gate of the upper bridge switching transistor Q1. A source of the upper bridge switching transistor Q1 is connected to a drain of the lower bridge switching transistor Q2, and the upper bridge switching transistor Q1 has a third node P3. A cathode of the diode D1 is connected to a terminal of the resistor $R_{on}1$, and an anode of the diode D1 is connected to a terminal of the resistor $R_{off}1$. The resistor $R_{off}1$ has another terminal connected to another terminal of the resistor $R_{on}1$. The capacitor $C_{1P}$ has a terminal connected to the positive turn-on voltage supply terminal VDD1 of the first drive power supply 522. Another terminal of the capacitor $C_{1P}$ is connected to a terminal of the capacitor $C_{1N}$, and the capacitor $C_{1P}$ has a first node P1. The first node P1 is connected to a third node P3. The capacitor $C_{1N}$ has another terminal connected to the negative turn-off voltage supply terminal VSS1 of the first drive power supply 522.

The drive chip U2 has a positive power pin VDD connected to a positive turn-on voltage supply terminal VDD2 of the second drive power supply 524. The drive chip U2 has a negative power pin VSS connected to a negative turn-off voltage supply terminal VSS2 of the second drive power supply 524. The drive chip U2 has an input pin IN connected to a second terminal of the control unit 56 to receive a turn-off control signal sent by the control unit 56. The drive chip U2 has an output pin OUT connected to a terminal of the resistor $R_{on}2$. The resistor $R_{on}2$ has another terminal connected to a gate of the lower bridge switching transistor Q2. A drain of the lower bridge switching transistor Q2 is connected to a source of the upper bridge switching transistor Q1, and a source of the lower bridge switching transistor Q2 is grounded. A cathode of the diode D2 is connected to a terminal of the resistor $R_{on}2$, and an anode of the diode D2 is connected to a terminal of the resistor $R_{off}2$. The resistor $R_{off}2$ has another terminal connected to another terminal of the resistor $R_{on}2$. The capacitor $C_{2P}$

has a terminal connected to the positive turn-on voltage supply terminal VDD2 of the second drive power supply 524. Another terminal of the capacitor $C_{2P}$ is connected to a terminal of the capacitor $C_{2N}$, and the capacitor $C_{2P}$ has a second node P2. The second node P2 is grounded. The capacitor $C_{2N}$ has another terminal connected to the negative turn-off voltage supply terminal VSS2 of the second drive power supply 524.

When the control unit 56 sends a turn-on control signal through the first terminal, the positive power pin VDD of the drive chip U1 is in communication with the output pin OUT of the drive chip U1. The first drive power supply 522 provides a positive voltage to the positive power pin VDD of the drive chip U1, the OUT pin of the drive chip U1 outputs the positive voltage, and the diode D1 is turned off. After voltage division by the resistor $R_{on}1$, a positive turn-on voltage is provided for the gate of the upper bridge switching transistor Q1, and the upper bridge switching transistor Q1 is turned on. It should be understood that the turn-on gate resistance is the resistor $R_{on}1$ in this case. When the control unit 56 sends a turn-off control signal through the first terminal, the negative power pin VSS of the drive chip U1 is in communication with the output pin OUT of the drive chip U1. The first drive power supply 522 provides a negative voltage to the negative power pin VSS of the drive chip U1, the OUT pin of the drive chip U1 outputs the negative voltage, and the diode D1 is turned on. After the resistor $R_{on}1$ and the resistor $R_{off}1$ are connected in parallel, a negative turn-off voltage is provided for the gate of the upper bridge switching transistor Q1, and the upper bridge switching transistor Q1 is turned off. It should be understood that the turn-off gate resistance may be a resistance value of the connected resistor $R_{on}1$ and resistor $R_{off}1$ in parallel.

When the control unit 56 sends a turn-on control signal through the second terminal, the positive power pin VDD of the drive chip U2 is in communication with the output pin OUT of the drive chip U2. The second drive power supply 524 provides a positive voltage to the positive power pin VDD of the drive chip U2, the OUT pin of the drive chip U2 outputs the positive voltage, and the diode D2 is turned off. After voltage division by the resistor $R_{on}2$, a positive turn-on voltage is provided for the gate of the lower bridge switching transistor Q2, and the lower bridge switching transistor Q2 is turned on. It should be understood that the turn-on gate resistance is the resistor $R_{on}2$ in this case. When the control unit 56 sends a turn-off control signal through the second terminal, the negative power pin VSS of the drive chip U2 is in communication with the output pin OUT of the drive chip U2. The second drive power supply 524 provides a negative voltage to the drive chip U2, the OUT pin of the drive chip U2 outputs the negative voltage, and the diode D2 is turned on. After the resistor $R_{on}2$ and the resistor $R_{off}2$ are connected in parallel, a negative turn-off voltage is provided for the gate of the lower bridge switching transistor Q2, and the lower bridge switching transistor Q2 is turned off. It should be understood that the turn-off gate resistance may be a resistance value of the connected resistor $R_{on}2$ and resistor $R_{off}2$ in parallel.

It should be noted that the diode has a turn-on resistance when being turned on. In some embodiments, the turn-on resistance of the diode may be considered when calculating the turn-on gate resistance and the turn-off gate resistance.

In some embodiments of the present disclosure, the drive unit 54 further comprises a second diode. The second diode has a cathode connected to the terminal of the first gate resistor and an anode connected to the cathode of the first diode.

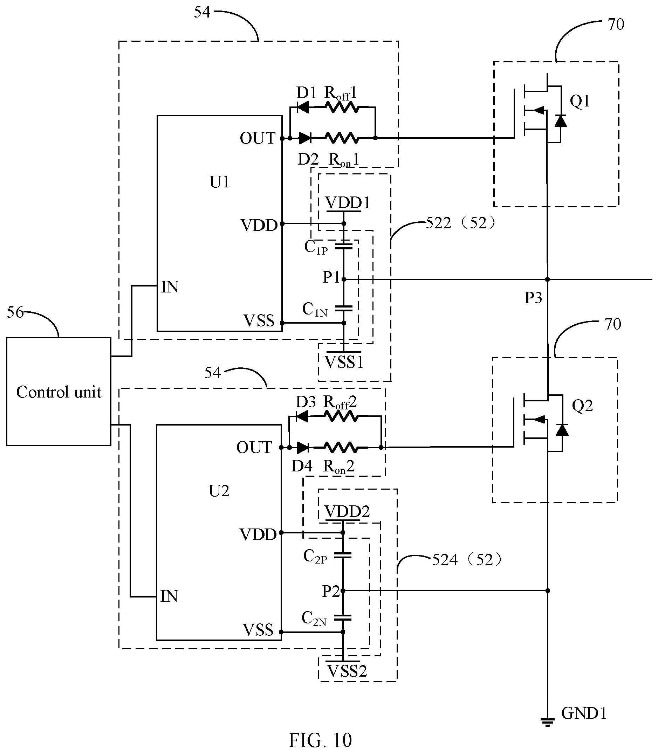

In an example, referring to FIG. 10, the drive chip comprises a chip U1 and a chip U2. The first gate resistor comprises a resistor $R_{on}1$ and a resistor $R_{on}2$. The second gate resistor comprises a resistor $R_{off}1$ and a resistor $R_{off}2$. The drive power supply 52 comprises a first drive power supply 522 and a second drive power supply 524. The switching transistor 70 comprises an upper bridge switching transistor Q1 and a lower bridge switching transistor Q2. The first coupling capacitor comprises a capacitor $C_{1P}$ and a capacitor $C_{2P}$. The second coupling capacitor comprises a capacitor $C_{1N}$ and a capacitor $C_{2N}$. The first diode comprises a diode D1 and a diode D3. The second diode comprises a diode D2 and a diode D4.

The drive chip U1 has a positive power pin VDD connected to a positive turn-on voltage supply terminal VDD1 of the first drive power supply 522. The drive chip U1 has a negative power pin VSS connected to a negative turn-off voltage supply terminal VSS1 of the first drive power supply 522. The drive chip U1 has an input pin IN connected to a first terminal of the control unit 56 to receive a turn-off control signal sent by the control unit 56. The drive chip U1 has an output pin OUT connected to an anode of the diode D2. A cathode of the diode D2 is connected to a terminal of the resistor $R_{on}1$. The resistor $R_{on}1$ has another terminal connected to a gate of the upper bridge switching transistor Q1. A source of the upper bridge switching transistor Q1 is connected to a drain of the lower bridge switching transistor Q2, and the upper bridge switching transistor Q1 has a third node P3. A cathode of the diode D1 is connected to an anode of the diode D2. An anode of the diode D1 is connected to a terminal of the resistor $R_{off}1$. The resistor $R_{off}1$ has another terminal connected to another terminal of the resistor $R_{on}1$. The capacitor $C_{1P}$ has a terminal connected to the positive turn-on voltage supply terminal VDD1 of the first drive power supply 522. Another terminal of the capacitor $C_{1P}$ is connected to a terminal of the capacitor $C_{1N}$, and the capacitor $C_{1P}$ has a first node P1. The first node P1 is connected to the third node P3. The capacitor $C_{1N}$ has another terminal connected to the negative turn-off voltage supply terminal VSS1 of the first drive power supply 522.

The drive chip U2 has a positive power pin VDD connected to the positive turn-on voltage supply terminal VDD2 of the second drive power supply 524. The drive chip U2 has a negative power pin VSS connected to the negative turn-off voltage supply terminal VSS2 of the second drive power supply 524. The drive chip U2 has an input pin IN connected to a second terminal of the control unit 56 to receive the turn-off control signal sent by the control unit 56. The drive chip U2 has an output pin OUT connected to an anode of the diode D4. A cathode of diode D4 is connected to a terminal of resistor $R_{on}2$.

The resistor $R_{on}2$ has another terminal connected to a gate of the lower bridge switching transistor Q2. A cathode of the diode D3 is connected to the anode of the diode D4. An anode of the diode D3 is connected to a terminal of the resistor $R_{off}2$. The resistor $R_{off}2$ has another terminal connected to another terminal of the resistor $R_{on}2$. The drain of the lower bridge switching transistor Q2 is connected to the source of the upper bridge switching transistor Q1, and the source of the lower bridge switching transistor Q2 is grounded. The capacitor $C_{2P}$ has a terminal connected to the positive turn-on voltage supply terminal VDD2 of the second drive power supply 524. Another terminal of the capacitor $C_{2P}$ is connected to a terminal of the capacitor $C_{2N}$, and the capacitor $C_{2P}$ has a second node P2. The second node P2 is grounded. The capacitor $C_{2N}$ has another terminal connected to the negative turn-off voltage supply terminal VSS2 of the second drive power supply 524.

When the control unit 56 sends a turn-on control signal through the first terminal, the positive power pin VDD of the drive chip U1 is in communication with the output pin OUT of the drive chip U1. The first drive power supply 522 provides a positive voltage to the positive power pin VDD of the drive chip U1, and the OUT pin of the drive chip U1 outputs the positive voltage. The diode D2 is turned on, and the diode D1 is turned off. After voltage division by the resistor $R_{on}1$, a positive turn-on voltage is provided for the gate of the upper bridge switching transistor Q1, and the upper bridge switching transistor Q1 is turned on. It should be understood that the turn-on gate resistance is the resistor $R_{on}1$ in this case. When the control unit 56 sends a turn-off control signal through the first terminal, the negative power pin VSS of the drive chip U1 is in communication with the output pin OUT of the drive chip U1. The first drive power supply 522 provides a negative voltage to the negative power pin VSS of the drive chip U1, and the OUT pin of the drive chip U1 outputs the negative voltage. The diode D1 is turned on, and the diode D2 is turned off. After voltage division by the resistor $R_{off}1$, a negative turn-off voltage is provided for the gate of the upper bridge switching transistor Q1, and the upper bridge switching transistor Q1 is turned off. It should be understood that the turn-off gate resistance is a resistance value of the resistor $R_{off}1$ in this case.

When the control unit 56 sends a turn-on control signal through the second terminal, the positive power pin VDD of the drive chip U2 is in communication with the output pin OUT of the drive chip U2. The second drive power supply 524 provides a positive voltage to the positive power pin VDD of the drive chip U2, and the OUT pin of the drive chip U2 outputs the positive voltage. The diode D4 is turned on, and the diode D3 is turned off. After voltage division by the resistor $R_{on}2$, a positive turn-on voltage is provided for the gate of the lower bridge switching transistor Q2, and the lower bridge switching transistor Q2 is turned on. It should be understood that at this time, the turn-on gate resistance is the resistor $R_{on}2$ in this case. When the control unit 56 sends a turn-off control signal through the second terminal, the negative power pin VSS of the drive chip U2 is in communication with the output pin OUT of the drive chip U2. The second drive power supply 524 provides a negative voltage to the drive chip U2, and the OUT pin of the drive chip U2 outputs the negative voltage. The diode D3 is turned on, and the diode D4 is turned off. After voltage division by the resistor $R_{off}2$, a negative turn-off voltage is provided for the gate of the lower bridge switching transistor Q2, and the lower bridge switching transistor Q2 is turned off. It should be understood that the turn-off gate resistance is a resistance value of the resistor $R_{off}2$ in this case.

It should be noted that the diode has a turn-on resistance when being turned on. In some embodiments, the turn-on resistance of the diode may be considered when calculating the turn-on gate resistance and the turn-off gate resistance.

In some embodiments of the present disclosure, the drive unit 54 further comprises a first diode and a second gate resistor. The first diode has a cathode connected to the terminal of the first gate resistor and an anode connected to another terminal of the first gate resistor. The second gate resistor has a terminal connected to the anode of the first diode, and another terminal connected to the gate of the switching transistor.

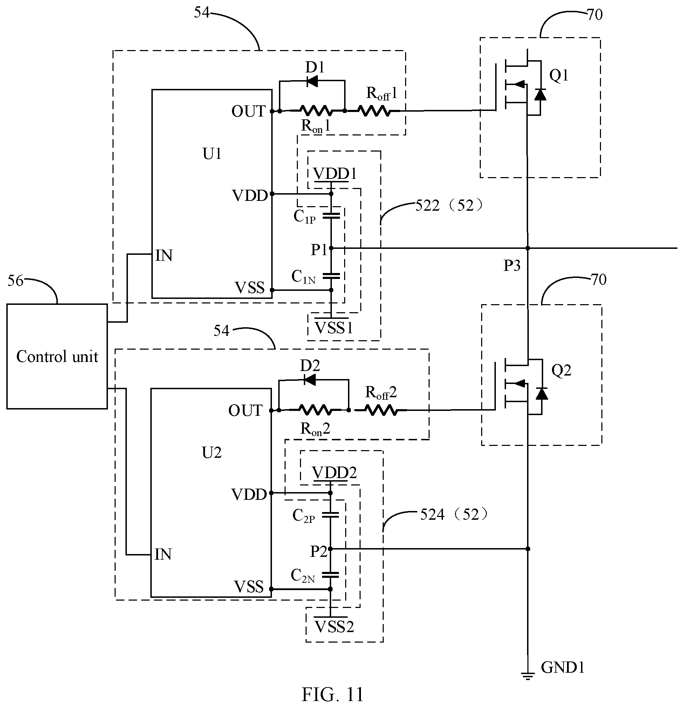

In an example, referring to FIG. 11, the drive chip comprises a chip U1 and a chip U2. The first gate resistor comprises a resistor $R_{on}1$ and a resistor $R_{on}2$. The second gate resistor comprises a resistor $R_{off}1$ and the resistor $R_{off}2$. The drive power supply 52 comprises a first drive power supply 522 and a second drive power supply 524. The switching transistor 70 comprises an upper bridge switching transistor Q1 and a lower bridge switching transistor Q2. The first coupling capacitor comprises a capacitor $C_{1P}$ and a capacitor $C_{2P}$. The second coupling capacitor comprises a capacitor $C_{1N}$ and a capacitor $C_{2N}$. The first diode comprises a diode D1 and a diode D2.

The drive chip U1 has a positive power pin VDD connected to a positive turn-on voltage supply terminal VDD1 of the first drive power supply 522. The drive chip U1 has a negative power pin VSS connected to a negative turn-off voltage supply terminal VSS1 of the first drive power supply 522. The drive chip U1 has an input pin IN connected to a first terminal of the control unit 56 to receive a turn-off control signal sent by the control unit 56. The drive chip U1 has an output pin OUT connected to a terminal of the resistor $R_{on}1$. The resistor $R_{on}1$ has another terminal connected to a terminal of the resistor $R_{off}1$. The resistor $R_{off}1$ has another terminal connected to a gate of the upper bridge switching transistor Q1. A source of the upper bridge switching transistor Q1 is connected to a drain of the lower bridge switching transistor Q2, and the upper bridge switching transistor Q1 has a third node P3. A cathode of the diode D1 is connected to a terminal of the resistor $R_{on}1$, and an anode of the diode D1 is connected to another terminal of the resistor $R_{on}1$. The capacitor $C_{1P}$ has a terminal connected to the positive turn-on voltage supply terminal VDD1 of the first drive power supply 522. Another terminal of the capacitor $C_{1P}$ is connected to a terminal of the capacitor $C_{1N}$, and the capacitor $C_{1P}$ has a first node P1. The first node P1 is connected to the third node P3. The capacitor $C_{1N}$ has another terminal connected to the negative turn-off voltage supply terminal VSS1 of the first drive power supply 522.

The drive chip U2 has a positive power pin VDD connected to the positive turn-on voltage supply terminal VDD2 of the second drive power supply 524. The drive chip U2 has a negative power pin VSS connected to the negative turn-off voltage supply terminal VSS2 of the second drive power supply 524. The drive chip U2 has an input pin IN connected to a second terminal of the control unit 56 to receive the turn-off control signal sent by the control unit 56. The drive chip U2 has an output pin OUT connected to a terminal of the resistor $R_{on}2$. The resistor $R_{on}2$ has another terminal connected to a terminal of the resistor $R_{off}2$. The resistor $R_{off}2$ has another terminal connected to the gate of the lower bridge switching transistor Q2. The drain of the lower bridge switching transistor Q2 is connected to the source of the upper bridge switching transistor Q1, and the source of the lower bridge switching transistor Q2 is grounded. A cathode of the diode D2 is connected to a terminal of the resistor $R_{on}2$, and an anode of the diode D2 is connected to a terminal of the resistor $R_{on}2$. The capacitor $C_{2P}$ has a terminal connected to the positive turn-on voltage supply terminal VDD2 of the second drive power supply 524. Another terminal of the capacitor $C_{2P}$ is connected to a terminal of the capacitor $C_{2N}$, the capacitor $C_{2P}$ has a second node P2. The second node P2 is grounded. The capacitor $C_{2N}$ has another terminal connected to the negative turn-off voltage supply terminal VSS2 of the second drive power supply 524.

When the control unit 56 sends a turn-on control signal through the first terminal, the positive power pin VDD of the drive chip U1 is in communication with the output pin OUT of the drive chip U1. The first drive power supply 522 provides a positive voltage to the positive power pin VDD of the drive chip U1, and the OUT pin of the drive chip U1 outputs the positive voltage. The diode D1 is turned off. After voltage division through the resistor $R_{on}1$ and the resistor $R_{off}1$ connected in series, a positive turn-on voltage is provided for the gate of the upper bridge switching transistor Q1, and the upper bridge switching transistor Q1 is turned on. It should be understood that, in this case, the turn-on gate resistance is a resistance value of the connected resistor $R_{on}1$ and resistor $R_{off}1$ in series. When the control unit 56 sends a turn-off control signal through the first terminal, the negative power pin VSS of the drive chip U1 is in communication with the output pin OUT of the drive chip U1. The first drive power supply 522 provides a negative voltage to the negative power pin VSS of the drive chip U1, and the OUT pin of the drive chip U1 outputs the negative voltage. The diode D1 is turned on, and the resistor $R_{on}1$ is short-circuited. After voltage division by the resistor $R_{off}1$, a negative turn-off voltage is provided for the gate of the upper bridge switching transistor Q1, and the upper bridge switching transistor Q1 is turned off. It should be understood that the turn-off gate resistance may be a resistance value of the resistor $R_{off}1$ in this case.

When the control unit 56 sends a turn-on control signal through the second terminal, the positive power pin VDD of the drive chip U2 is in communication with the output pin OUT of the drive chip U2. The second drive power supply 524 provides a positive voltage to the positive power pin VDD of the drive chip U2, and the OUT pin of the drive chip U2 outputs a positive voltage. The diode D2 is turned off. After voltage division through the connected resistor $R_{on}1$ and resistor $R_{off}1$ in series, a positive turn-on voltage is provided for the gate of the lower bridge switching transistor Q2, and the lower bridge switching transistor Q2 is turned on. It should be understood that, in this case, the turn-on gate resistance is a resistance value of the connected resistor $R_{on}1$ and resistor $R_{off}1$ in series. When the control unit 56 sends a turn-off control signal through the second terminal, the negative power pin VSS of the drive chip U2 is in communication with the output pin OUT of the drive chip U2. The second drive power supply 524 provides a negative voltage to the negative power pin VSS of the drive chip U2, and the OUT pin of the drive chip U2 outputs the negative voltage. The diode D2 is turned on, and the resistor $R_{on}2$ is short-circuited. After voltage division by the resistor $R_{off}2$, a negative turn-off voltage is provided for the gate of the lower bridge switching transistor Q2, and the lower bridge switching transistor Q2 is turned off. It should be understood that the turn-off gate resistance may be a resistance value of the resistor $R_{off}2$ in this case.

It should be noted that the diode has a turn-on resistance when being turned on. In some embodiments, the turn-on resistance of the diode may be considered when calculating the turn-on gate resistance and the turn-off gate resistance.

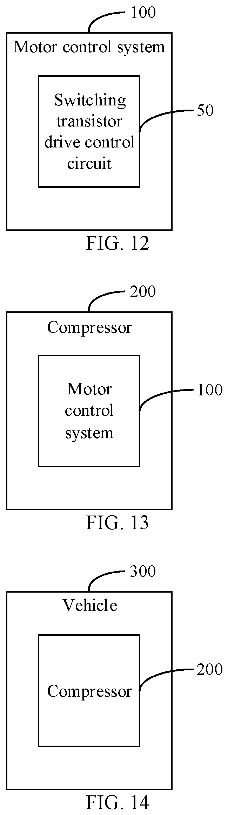

In order to implement the above embodiments, embodiments of the present disclosure further provide a motor control system. FIG. 12 is a structural block diagram of a motor control system according to an embodiment of the present disclosure. As shown in FIG. 12, the motor control system100 comprises the switching transistor drive control circuit 50 according to any one of the above embodiments.

In order to implement the above embodiments, embodiments of the present disclosure further provide a compressor. FIG. 13 is a structural block diagram of a compressor according to an embodiment of the present disclosure. As shown in FIG. 13, the compressor 200 comprises the motor control system 100 according to the above embodiments.

In order to implement the above embodiments, embodiments of the present disclosure further provide a vehicle. FIG. 14 is a structural block diagram of a vehicle according to an embodiment of the present disclosure. As shown in FIG. 14, the vehicle 300 comprises the compressor 200 according to the above embodiments.

The vehicle 300 may be a new energy vehicle. In some embodiments, the new energy vehicle may be a pure electric vehicle using an electric motor as a main driving force. In other embodiments, the new energy vehicle may also be a hybrid vehicle using an internal combustion engine and an electric motor as main driving forces. With regard to the internal combustion engine and the electric motor for providing driving power for the new energy vehicle mentioned in the above embodiments, the internal combustion engine may employ gasoline, diesel oil, hydrogen, or the like as fuel, and the electric motor may employ a power battery, hydrogen fuel cell, or the like to providing electric energy, and the present disclosure is not limited in this regards. It should be noted that the embodiments are only an exemplary description of a structure of the new energy vehicle, and is not intended to limit the scope of the present disclosure.

In addition, in some embodiments, the compressor applicable to the new energy vehicle according to the embodiments of the present disclosure may be an electric compressor comprising a driving portion and a compression portion. The driving portion in the electric compressor is configured to drive the compression portion to perform a compression operation. For example, the driving portion may be a driving motor comprising a rotor and a stator. In addition, in some embodiments, the electric compressor may be a low back pressure compressor. The drive portion may be disposed at a low pressure chamber in communication with an intake port of the compressor. The compression portion may be disposed at a high pressure chamber in communication with an exhaust port of the compressor. Further, in some embodiments, the electric compressor may be a horizontal compressor, and the drive portion and the compression portion may be arranged transversely.

In the motor control system 100, the compressor 200, and the vehicle 300 according to the embodiments of the present disclosure, the turn-off negative voltage upper limit absolute value of the switching transistor is obtained by inputting the acquired turn-off gate resistance and turn-on gate resistance of the switching transitory, the acquired bus voltage, and the acquired minimum turn-on voltage of the switching transistor into the first turn-off negative voltage model, and a turn-off negative voltage lower limit absolute value of the switching transistor is obtained by inputting the acquired turn-off gate resistance and turn-on gate resistance, the acquired bus voltage, and the maximum bearable negative voltage absolute value of the switching transistor into the second turn-off negative voltage model. Then, the turn-off negative voltage interval of the switching transistor is accurately determined based on the turn-off negative voltage upper limit absolute value of the switching transistor and the turn-off negative voltage lower limit absolute value of the switching transistor. Therefore, when the negative voltage turn-off control is performed on the switching transistor by using the turn-off negative voltage interval, the switching transistor can be effectively prevented from being turned on mistakenly, and the switching transistor can be protected, which can prolong service life of the switching transistor.

It should be noted that the explanatory description of the embodiments and beneficial effects of the switching transistor drive control circuit is also adapted to the motor control system 100, the compressor 200, and the vehicle 300 of the present disclosure, and thus the detailed description thereof will be omitted herein to avoid redundancy.

Those skilled in the art should understand that the embodiments of the present disclosure can be provided as a method, a system, or a computer program product. Therefore, the present disclosure may adopt a form of a complete hardware embodiment, a complete software embodiment, or an embodiment combining software and hardware. In addition, the present disclosure may employ a form of a computer program product implemented on one or more computer-usable storage media (comprising but being not limited to disk storage, Compact Disc Read-Only Memory (CD-ROM), optical storage, etc.) containing computer-usable program codes.

The present disclosure is described with reference to flowcharts and/or block diagrams of the method, the device (system), and the computer program product according to the embodiments of the present disclosure. It should be understood that each process and/or block in the flowcharts and/or block diagrams, and a combination of processes and/or blocks in the flowcharts and/or block diagrams may be implemented by computer program instructions. These computer program instructions can be provided to a processor of a general-purpose computer, a special-purpose computer, an embedded processor, or other programmable data processing device to generate a machine, such that instructions executed by the processor of the computer or other programmable data processing devices generate an apparatus for implementing functions specified in one or more processes in the flowchart and/or one or more blocks in the block diagram.

These computer program instructions may further be stored in a computer-readable memory that can guide a computer or other programmable data processing devices to work in a specific manner, such that instructions stored in the computer-readable memory produce an article of manufacture comprising an instruction device. The instruction device implements functions specified in one or more processes in the flowchart and/or one or more blocks in the block diagram.

These computer program instructions can further be loaded on a computer or other programmable data processing devices to enable a series of operation steps to be executed on the computer or other programmable devices for producing computer-implemented processing, such that instructions executed on the computer or other programmable devices provide actions for implementing functions specified in one or more processes in the flowchart and/or one or more blocks in the block diagram.

In the description of this specification, description with reference to the terms "an embodiment", "some embodiments", "exemplary embodiments", "examples" "specific examples", or "some examples" etc., mean that specific features, structure, materials or characteristics described in conjunction with the embodiment or example are comprised in at least one embodiment or example of the present disclosure. In this specification, the schematic representations of the above terms do not necessarily refer to the same embodiment or example. Moreover, the described specific features, structures, materials, or characteristics may be combined in any one or more embodiments or examples in a suitable manner.

In addition, terms "first" and "second" are only used for descriptive purposes, and cannot be understood as indicating or implying relative importance or implicitly indicating the number of the indicated technical features. Therefore, the features associated with "first" and "second" may explicitly or implicitly comprise at least one of the features. In the description of the present disclosure, "plurality" means at least two, e.g., two, three, four, etc., unless otherwise specifically defined.

In the present disclosure, unless otherwise clearly specified and limited, terms such as "install", "connect", "connect to", "fix" and the like should be understood in a broad sense. For example, it may be a fixed connection or a detachable connection or connection as one piece; mechanical connection or electrical connection; direct connection or indirect connection through an intermediate; internal communication of two components or the interaction relationship between two components, unless otherwise clearly limited. For those skilled in the art, the specific meaning of the above-mentioned terms in the present disclosure should be understood according to specific circumstances.

It should be noted that, in order to make the description simple, all possible combinations of the technical features in the foregoing embodiments are not described. However, as long as there is no conflict between the technical features in the embodiments, any combination of technical features in the above-described embodiments may be adopted, which should be considered in the scope of this specification.

Although embodiments of the present disclosure have been shown and described above, it should be understood that the above embodiments are merely exemplary, and cannot be construed as limitations of the present disclosure. For those skilled in the art, changes, alternatives, and modifications can be made to the above embodiments without departing from the scope of the present invention as defined in the appended claims.

**Claims**

1. A processor-implemented method for determining a turn-off negative voltage of a switching transistor (70), comprising:

   (S11) determining a first turn-off negative voltage model and a second turn-off negative voltage model;
   (S13) acquiring a turn-off gate resistance and a turn-on gate resistance of the switching transistor (70), a bus voltage, and a minimum turn-on voltage and a maximum bearable negative voltage absolute value of the switching transistor (70);
   (S15) inputting the turn-off gate resistance, the turn-on gate resistance, the bus voltage, and the minimum turn-on voltage into the first turn-off negative voltage model to obtain a turn-off negative voltage upper limit absolute value of the switching transistor (70), and inputting the turn-off gate resistance, the turn-on gate resistance, the bus voltage, and the maximum bearable negative voltage absolute value into the second turn-off negative voltage model to obtain a turn-off negative voltage lower limit absolute value of the switching transistor (70); and
   (S17) determining a turn-off negative voltage interval of the switching transistor (70) based on the turn-off negative voltage upper limit absolute value and the turn-off negative voltage lower limit absolute value.

2. The method according to claim 1, wherein the first turn-off negative voltage model is expressed as:

$$V_{SS\_min}=\lambda_1 * f_1(R_{G\_on}, R_{G\_off}, V_{DC})-V_{th},$$

   where:

   $V_{SS\_min}$ represents the turn-off negative voltage upper limit absolute value;
   $\lambda_1$ represents a first derating parameter;
   $f_1(R_{G\_on}, R_{G\_off}, V_{DC})$ represents a function expression corresponding to the first turn-off negative voltage model;
   $R_{G\_on}$ represents the turn-on gate resistance;
   $R_{G\_off}$ represents the turn-off gate resistance;
   $V_{DC}$ represents the bus voltage; and
   $V_{th}$ represents the minimum turn-on voltage; and/or
   the second turn-off negative voltage model is expressed as:

$$V_{SS\_max}=V_{GS\_max}-\lambda_2 * f_2(R_{G\_on}, R_{G\_off}, V_{DC}),$$

   where:

   $V_{SS\_max}$ represents the turn-off negative voltage lower limit absolute value;
   $\lambda_2$ represents a second derating parameter;
   $f_2(R_{G\_on}, R_{G\_off}, V_{DC})$ represents a function expression corresponding to the second turn-off negative voltage model;

$R_{G\_on}$ represents the turn-on gate resistance;

$R_{G\_off}$ represents the turn-off gate resistance;

$V_{DC}$ represents the bus voltage; and

$V_{GS\_max}$ represents the maximum bearable negative voltage absolute value; and/or

wherein said (S17) determining the turn-off negative voltage interval of the switching transistor (70) based on the turn-off negative voltage upper limit absolute value and the turn-off negative voltage lower limit absolute value comprises:

(S171) setting a negative value of the turn-off negative voltage upper limit absolute value as an upper limit voltage of the turn-off negative voltage, and setting a negative value of the turn-off negative voltage lower limit absolute value as a lower limit voltage of the turn-off negative voltage; and

(S173) determining the turn-off negative voltage interval based on the upper limit voltage of the turn-off negative voltage and the lower limit voltage of the turn-off negative voltage; and/or

wherein the switching transistor (70) is a silicon-carbide Metal Oxide Semiconductor (MOS) transistor.

3. An apparatus (10) for determining a turn-off negative voltage of a switching transistor (70), comprising:

a first determining module (12) configured to determine a first turn-off negative voltage model and a second turn-off negative voltage model;

an acquiring module (14) configured to acquire a turn-off gate resistance and a turn-on gate resistance of the switching transistor (70), a bus voltage, and a minimum turn-on voltage and a maximum bearable negative voltage absolute value of the switching transistor (70); and

a second determining module (16) configured to: input the turn-off gate resistance, the turn-on gate resistance, the bus voltage, and the minimum turn-on voltage into the first turn-off negative voltage model to obtain a turn-off negative voltage upper limit absolute value of the switching transistor (70); input the turn-off gate resistance, the turn-on gate resistance, the bus voltage, and the maximum bearable negative voltage absolute value into the second turn-off negative voltage model to obtain a turn-off negative voltage lower limit absolute value of the switching transistor (70); and determine a turn-off negative voltage interval of the switching transistor (70) based on the turn-off negative voltage upper limit absolute value and the turn-off negative voltage lower limit absolute value.

4. An inverter (30), comprising:

a memory (32);

a processor (34); and

a program (36) determining a turn-off negative voltage of a switching transistor (70) stored in the memory (32) and executable on the processor (34),

wherein the processor (34) is configured to implement, when executing the program (36) for determining the turn-off negative voltage of the switching transistor (70), a method according to claim 1 or 2.

5. A computer-readable storage medium, having a program (36) for determining a turn-off negative voltage of a switching transistor (70) stored thereon, wherein the program (36) for determining the turn-off negative voltage of the switching transistor (70), when executed by a processor (34), implements a method according to claim 1 or 2.

6. A switching transistor drive control circuit (50), comprising:

a drive power supply (52);

a drive unit (54); and

a control unit (56), wherein:

the control unit (56) is configured to acquire a turn-off negative voltage interval of a switching transistor (70) by implementing a method according to claim 1 or 2, and control the drive power supply (52) to provide a negative turn-off voltage to the drive unit (54) based on the turn-off negative voltage interval; and

the drive unit (54) is configured to drive, in response to receiving a turn-off control signal, the switching transistor (70) to be turned off based on the negative turn-off voltage.

7. The switching transistor drive control circuit (50) according to claim 6, wherein the drive unit (54) comprises:

a drive chip (U1, U2) having a positive power pin (VDD) connected to a positive turn-on voltage supply terminal (VDD1, VDD2) of the drive power supply (52), and having a negative power pin (VSS) connected to a negative turn-off voltage supply terminal (VSS1, VSS2) of the drive power supply (52), and an input pin (IN) of the drive chip connected to the control unit (56) to receive the turn-off control signal sent by the control unit (56); and a first gate resistor having a terminal connected to an output pin (OUT) of the drive chip (U1, U2), and having an other terminal connected to a gate of the switching transistor (70).

8. The switching transistor drive control circuit (50) according to claim 7, wherein the drive unit (54) further comprises:

a first diode having a cathode connected to the terminal of the first gate resistor; and a second gate resistor having a terminal connected to an anode of the first diode, and having another terminal connected to the other terminal of the first gate resistor.

9. The switching transistor drive control circuit (50) according to claim 8, wherein the drive unit (54) further comprises: a second diode having a cathode connected to the terminal of the first gate resistor and having an anode connected to a cathode of the first diode.

10. The switching transistor drive control circuit (50) according to any one of claims 7 to 9, wherein the drive unit (54) further comprises:

the first diode having the cathode connected to the terminal of the first gate resistor and the anode connected to the other terminal of the first gate resistor; and the second gate resistor having the terminal connected to the anode of the first diode, and the other terminal connected to the gate of the switching transistor (70).

11. The switching transistor drive control circuit (50) according to any one of claims 7 to 10, wherein the drive unit (54) further comprises:

a first coupling capacitor having a terminal connected to the positive turn-on voltage supply terminal (VDD1, VDD2) of the drive power supply (52); and a second coupling capacitor having a terminal connected to another terminal of the first coupling capacitor, and another terminal connected to the negative turn-off voltage supply terminal (VSS1, VSS2) of the drive power supply (52).

12. The switching transistor drive control circuit (50) according to claim 11, wherein:

when the switching transistor (70) is an upper bridge switching transistor (Q1), a node between the first coupling capacitor and the second coupling capacitor is connected to a midpoint of a bridge arm at which the upper bridge switching transistor (Q1) is located; and when the switching transistor (70) is a lower bridge switching transistor (Q2), a node between the first coupling capacitor and the second coupling capacitor is grounded.

13. A motor control system (100), comprising a switching transistor drive control circuit (50) according to any one of claims 6 to 12.

14. A compressor (200), comprising a motor control system (100) according to claim 13.

15. A vehicle (300), comprising a compressor (200) according to claim 14.


**Patentansprüche**

1. Prozessorimplementiertes Verfahren zum Bestimmen einer negativen Abschaltspannung eines Schalttransistors (70), umfassend:

(S11) Bestimmen eines ersten Modells der negativen Abschaltspannung und eines zweiten Modells der negativen Abschaltspannung;
(S13) Erfassen eines Abschalt-Gate-Widerstands und eines Einschalt-Gate-Widerstands des Schalttransistors (70), einer Zwischenkreisspannung sowie einer minimalen Einschaltspannung und eines maximal ertragbaren Absolutwerts der negativen Spannung des Schalttransistors (70);
(S15) Eingeben des Abschalt-Gate-Widerstands, des Einschalt-Gate-Widerstands, der Zwischenkreisspannung und der minimalen Einschaltspannung in das erste Modell der negativen Abschaltspannung, um einen oberen Grenzabsolutwert der negativen Abschaltspannung des Schalttransistors (70) zu erhalten, und Eingeben des Abschalt-Gate-Widerstands, des Einschalt-Gate-Widerstands, der Zwischenkreisspannung und des maximal ertragbaren Absolutwerts der negativen Spannung in das zweite Modell der negativen Abschaltspannung, um einen unteren Grenzabsolutwert der negativen Abschaltspannung des Schalttransistors (70) zu erhalten; und
(S17) Bestimmen eines Intervalls der negativen Abschaltspannung des Schalttransistors (70) auf Grundlage des oberen Grenzabsolutwerts der negativen Abschaltspannung und des unteren Grenzabsolutwerts der negativen Abschaltspannung.

2. Verfahren nach Anspruch 1, wobei das erste Modell der negativen Abschaltspannung ausgedrückt wird als:

$$V_{SS\_min} = \lambda_1 * f_1(R_{G\_on}, R_{G\_off}, V_{DC}) - V_{th}$$

wobei:

$V_{ss\_min}$ den oberen Grenzabsolutwert der negativen Abschaltspannung darstellt;
$\lambda_1$ einen ersten Derating-Parameter darstellt;
$f_1(R_{G\_on}, R_{G\_off}, V_{DC})$ einen Funktionsausdruck darstellt, der dem ersten Modell der negativen Abschaltspannung entspricht;
$R_{G\_on}$ den Einschalt-Gate-Widerstand darstellt;
$R_{G\_off}$ den Abschalt-Gate-Widerstand darstellt;
$V_{DC}$ die Zwischenkreisspannung darstellt; und
$V_{th}$ die minimale Einschaltspannung darstellt; und/oder
wobei das zweite Modell der negativen Abschaltspannung ausgedrückt wird als:

$$V_{SS\_max} = V_{GS\_max} - \lambda_2 * f_2(R_{G\_on}, R_{G\_off}, V_{DC})$$

wobei:

$V_{ss\_max}$ den unteren Grenzabsolutwert der negativen Abschaltspannung darstellt;
$\lambda_2$ einen zweiten Derating-Parameter darstellt;
$f_2(R_{G\_on}, R_{G\_off}, V_{DC})$ einen Funktionsausdruck darstellt, der dem zweiten Modell der negativen Abschaltspannung entspricht;
$R_{G\_on}$ den Einschalt-Gate-Widerstand darstellt;
$R_{G\_off}$ den Abschalt-Gate-Widerstand darstellt;
$V_{DC}$ die Zwischenkreisspannung darstellt; und
$V_{GS\_max}$ den maximal ertragbaren Absolutwert der negativen Spannung darstellt; und/oder

wobei das genannte (S17) Bestimmen des Intervalls der negativen Abschaltspannung des Schalttransistors (70) auf Grundlage des oberen Grenzabsolutwerts der negativen Abschaltspannung und des unteren Grenzabsolutwerts der negativen Abschaltspannung umfasst:

(S171) Festlegen eines negativen Werts des oberen Grenzabsolutwerts der negativen Abschaltspannung als obere Grenzspannung der negativen Abschaltspannung und Festlegen eines negativen Werts des unteren Grenzabsolutwerts der negativen Abschaltspannung als untere Grenzspannung der negativen Abschaltspannung; und
(S173) Bestimmen des Intervalls der negativen Abschaltspannung auf Grundlage der oberen Grenzspannung der negativen Abschaltspannung und der unteren Grenzspannung der negativen Abschaltspannung; und/oder

wobei der Schalttransistor (70) ein Siliziumkarbid-Metalloxid-Halbleiter-Transistor, MOS-Transistor, ist.

3. Vorrichtung (10) zum Bestimmen einer negativen Abschaltspannung eines Schalttransistors (70), umfassend:

ein erstes Bestimmungsmodul (12), das dafür konfiguriert ist, ein erstes Modell der negativen Abschaltspannung und ein zweites Modell der negativen Abschaltspannung zu bestimmen;

ein Erfassungsmodul (14), das dafür konfiguriert ist, einen Abschalt-Gate-Widerstand und einen Einschalt-Gate-Widerstand des Schalttransistors (70), eine Zwischenkreisspannung sowie eine minimale Einschaltspannung und einen maximal ertragbaren Absolutwert der negativen Spannung des Schalttransistors (70) zu erfassen; und

ein zweites Bestimmungsmodul (16), das dafür konfiguriert ist: den Abschalt-Gate-Widerstand, den Einschalt-Gate-Widerstand, die Zwischenkreisspannung und die minimale Einschaltspannung in das erste Modell der negativen Abschaltspannung einzugeben, um einen oberen Grenzabsolutwert der negativen Abschaltspannung des Schalttransistors (70) zu erhalten; den Abschalt-Gate-Widerstand, den Einschalt-Gate-Widerstand, die Zwischenkreisspannung und den maximal ertragbaren Absolutwert der negativen Spannung in das zweite Modell der negativen Abschaltspannung einzugeben, um einen unteren Grenzabsolutwert der negativen Abschaltspannung des Schalttransistors (70) zu erhalten; und ein Intervall der negativen Abschaltspannung des Schalttransistors (70) auf Grundlage des oberen Grenzabsolutwerts der negativen Abschaltspannung und des unteren Grenzabsolutwerts der negativen Abschaltspannung zu bestimmen.

4. Wechselrichter (30), umfassend:

einen Speicher (32);
einen Prozessor (34); und
ein Programm (36) zum Bestimmen einer negativen Abschaltspannung eines Schalttransistors (70), das in dem Speicher (32) gespeichert und auf dem Prozessor (34) ausführbar ist,
wobei der Prozessor (34) dafür konfiguriert ist, bei Ausführung des Programms (36) zum Bestimmen der negativen Abschaltspannung des Schalttransistors (70) ein Verfahren nach Anspruch 1 oder 2 zu implementieren.

5. Computerlesbares Speichermedium, auf dem ein Programm (36) zum Bestimmen einer negativen Abschaltspannung eines Schalttransistors (70) gespeichert ist, wobei das Programm (36) zum Bestimmen der negativen Abschaltspannung des Schalttransistors (70), wenn es von einem Prozessor (34) ausgeführt wird, ein Verfahren nach Anspruch 1 oder 2 implementiert.

6. Schalttransistor-Ansteuerungssteuerschaltung (50), umfassend:

eine Ansteuerungsstromversorgung (52); eine Ansteuerungseinheit (54); und
eine Steuereinheit (56), wobei:

die Steuereinheit (56) dafür konfiguriert ist, ein Intervall der negativen Abschaltspannung eines Schalttransistors (70) durch Implementieren eines Verfahrens nach Anspruch 1 oder 2 zu erfassen und die Ansteuerungsstromversorgung (52) zu steuern, um der Ansteuerungseinheit (54) eine negative Abschaltspannung auf Grundlage des Intervalls der negativen Abschaltspannung bereitzustellen; und
die Ansteuerungseinheit (54) dafür konfiguriert ist, als Reaktion auf den Empfang eines Abschaltsteuersignals den Schalttransistor (70) auf Grundlage der negativen Abschaltspannung zum Abschalten anzusteuern.

7. Schalttransistor-Ansteuerungssteuerschaltung (50) nach Anspruch 6, wobei die Ansteuerungseinheit (54) umfasst:

einen Ansteuerungschip (U1, U2), der einen positiven Leistungsanschluss (VDD) aufweist, der mit einem positiven Einschaltspannungs-Versorgungsanschluss (VDD1, VDD2) der Ansteuerungsstromversorgung (52) verbunden ist, und der einen negativen Leistungsanschluss (VSS) aufweist, der mit einem negativen Abschaltspannungs-Versorgungsanschluss (VSS1, VSS2) der Ansteuerungsstromversorgung (52) verbunden ist, und wobei ein Eingangsanschluss (IN) des Ansteuerungschips mit der Steuereinheit (56) verbunden ist, um das von der Steuereinheit (56) gesendete Abschaltsteuersignal zu empfangen; und
einen ersten Gate-Widerstand, der einen Anschluss aufweist, der mit einem Ausgangsanschluss (OUT) des Ansteuerungschips (U1, U2) verbunden ist, und der einen anderen Anschluss aufweist, der mit einem Gate des Schalttransistors (70) verbunden ist.

8. Schalttransistor-Ansteuerungssteuerschaltung (50) nach Anspruch 7, wobei die Ansteuerungseinheit (54) ferner umfasst:

eine erste Diode, die eine Kathode aufweist, die mit dem Anschluss des ersten Gate-Widerstands verbunden ist; und

einen zweiten Gate-Widerstand, der einen Anschluss aufweist, der mit einer Anode der ersten Diode verbunden ist, und der einen anderen Anschluss aufweist, der mit dem anderen Anschluss des ersten Gate-Widerstands verbunden ist.

9. Schalttransistor-Ansteuerungssteuerschaltung (50) nach Anspruch 8, wobei die Ansteuerungseinheit (54) ferner umfasst:
eine zweite Diode, die eine Kathode aufweist, die mit dem Anschluss des ersten Gate-Widerstands verbunden ist, und die eine Anode aufweist, die mit einer Kathode der ersten Diode verbunden ist.

10. Schalttransistor-Ansteuerungssteuerschaltung (50) nach einem der Ansprüche 7 bis 9, wobei die Ansteuerungseinheit (54) ferner umfasst:

die erste Diode, die die mit dem Anschluss des ersten Gate-Widerstands verbundene Kathode und die mit dem anderen Anschluss des ersten Gate-Widerstands verbundene Anode aufweist; und
den zweiten Gate-Widerstand, der den mit der Anode der ersten Diode verbundenen Anschluss und den mit dem Gate des Schalttransistors (70) verbundenen anderen Anschluss aufweist.

11. Schalttransistor-Ansteuerungssteuerschaltung (50) nach einem der Ansprüche 7 bis 10, wobei die Ansteuerungseinheit (54) ferner umfasst:

einen ersten Koppelkondensator, der einen Anschluss aufweist, der mit dem positiven Einschaltspannungs-Versorgungsanschluss (VDD1, VDD2) der Ansteuerungsstromversorgung (52) verbunden ist; und
einen zweiten Koppelkondensator, der einen Anschluss aufweist, der mit einem weiteren Anschluss des ersten Koppelkondensators verbunden ist, und der einen weiteren Anschluss aufweist, der mit dem negativen Abschaltspannungs-Versorgungsanschluss (VSS1, VSS2) der Ansteuerungsstromversorgung (52) verbunden ist.

12. Schalttransistor-Ansteuerungssteuerschaltung (50) nach Anspruch 11, wobei:

wenn der Schalttransistor (70) ein oberer Brückenschalttransistor (Q1) ist, ein Knoten zwischen dem ersten Koppelkondensator und dem zweiten Koppelkondensator mit einem Mittelpunkt eines Brückenarms verbunden ist, an dem sich der obere Brückenschalttransistor (Q1) befindet; und
wenn der Schalttransistor (70) ein unterer Brückenschalttransistor (Q2) ist, ein Knoten zwischen dem ersten Koppelkondensator und dem zweiten Koppelkondensator geerdet ist.

13. Motorsteuersystem (100), umfassend eine Schalttransistor-Ansteuerungssteuerschaltung (50) nach einem der Ansprüche 6 bis 12.

14. Kompressor (200), umfassend ein Motorsteuersystem (100) nach Anspruch 13.

15. Fahrzeug (300), umfassend einen Kompressor (200) nach Anspruch 14.


**Revendications**

1. Procédé mis en œuvre par processeur pour déterminer une tension négative de blocage d'un transistor de commutation (70), comprenant :

(S11) la détermination d'un premier modèle de tension négative de blocage et d'un second modèle de tension négative de blocage ;
(S13) l'acquisition d'une résistance de grille de blocage et d'une résistance de grille d'amorçage du transistor de commutation (70), d'une tension de bus, ainsi que d'une tension minimale d'amorçage et d'une valeur absolue de tension négative maximale supportable du transistor de commutation (70) ;
(S15) l'entrée de la résistance de grille de blocage, de la résistance de grille d'amorçage, de la tension de bus et de la tension minimale d'amorçage dans le premier modèle de tension négative de blocage afin d'obtenir une valeur absolue de limite supérieure de tension négative de blocage du transistor de commutation (70), et l'entrée de la résistance de grille de blocage, de la résistance de grille d'amorçage, de la tension de bus et de la valeur absolue de tension négative maximale supportable dans le second modèle de tension négative de blocage afin d'obtenir une valeur absolue de limite inférieure de tension négative de blocage du transistor de commutation (70) ; et

(S17) la détermination d'un intervalle de tension négative de blocage du transistor de commutation (70) sur la base de la valeur absolue de limite supérieure de tension négative de blocage et de la valeur absolue de limite inférieure de tension négative de blocage.

2. Procédé selon la revendication 1, dans lequel le premier modèle de tension négative de blocage est exprimé comme suit :

$$V_{SS\_min} = \lambda_1 * f_1(R_{G\_on}, R_{G\_off}, V_{DC}) - V_{th}$$

où :

$V_{ss\_min}$ représente la valeur absolue de limite supérieure de tension négative de blocage ;
$\lambda_1$ représente un premier paramètre de déclassement ;
f1($R_{G\_on}$, $R_{G\_off}$, $V_{DC}$) représente une expression fonctionnelle correspondant au premier modèle de tension négative de blocage ;
$R_{G\_on}$ représente la résistance de grille d'amorçage ;
$R_{G\_off}$ représente la résistance de grille de blocage ;
$V_{DC}$ représente la tension de bus ; et
$V_{th}$ représente la tension minimale d'amorçage ; et/ou
le second modèle de tension négative de blocage est exprimé comme suit :

$$V_{SS\_max} = V_{GS\_max} - \lambda_2 * f_2(R_{G\_on}, R_{G\_off}, V_{DC})$$

où :

$V_{ss\_max}$ représente la valeur absolue de limite inférieure de tension négative de blocage ;
$\lambda_2$ représente un second paramètre de déclassement ;
$f_2$($R_{G\_on}$, $R_{G\_off}$, $V_{DC}$) représente une expression fonctionnelle correspondant au second modèle de tension négative de blocage ;
$R_{G\_on}$ représente la résistance de grille d'amorçage ;
$R_{G\_off}$ représente la résistance de grille de blocage ;
$V_{DC}$ représente la tension de bus ; et
$V_{GS\_max}$ représente la valeur absolue de tension négative maximale supportable ; et/ou dans lequel ladite étape (S17) de détermination de l'intervalle de tension négative de blocage du transistor de commutation (70) sur la base de la valeur absolue de limite supérieure de tension négative de blocage et de la valeur absolue de limite inférieure de tension négative de blocage comprend :

(S171) le réglage d'une valeur négative de la valeur absolue de limite supérieure de tension négative de blocage en tant que tension de limite supérieure de la tension négative de blocage, et le réglage d'une valeur négative de la valeur absolue de limite inférieure de tension négative de blocage en tant que tension de limite inférieure de la tension négative de blocage ; et

(S173) la détermination de l'intervalle de tension négative de blocage sur la base de la tension de limite supérieure de la tension négative de blocage et de la tension de limite inférieure de la tension négative de blocage ; et/ou

dans lequel le transistor de commutation (70) est un transistor métal-oxyde-semiconducteur (MOS) en carbure de silicium.

3. Appareil (10) pour déterminer une tension négative de blocage d'un transistor de commutation (70), comprenant :

un premier module de détermination (12) configuré pour déterminer un premier modèle de tension négative de blocage et un second modèle de tension négative de blocage ;

un module d'acquisition (14) configuré pour acquérir une résistance de grille de blocage et une résistance de grille d'amorçage du transistor de commutation (70), une tension de bus, ainsi qu'une tension minimale d'amorçage et une valeur absolue de tension négative maximale supportable du transistor de commutation (70) ; et

un second module de détermination (16) configuré pour : entrer la résistance de grille de blocage, la résistance de grille d'amorçage, la tension de bus et la tension minimale d'amorçage dans le premier modèle de tension négative de blocage afin d'obtenir une valeur absolue de limite supérieure de tension négative de blocage du transistor de commutation (70) ; entrer la résistance de grille de blocage, la résistance de grille d'amorçage, la tension de bus et la valeur absolue de tension négative maximale supportable dans le second modèle de tension négative de blocage afin d'obtenir une valeur absolue de limite inférieure de tension négative de blocage du transistor de commutation (70) ; et déterminer un intervalle de tension négative de blocage du transistor de commutation (70) sur la base de la valeur absolue de limite supérieure de tension négative de blocage et de la valeur absolue de limite inférieure de tension négative de blocage.

4. Onduleur (30), comprenant :

une mémoire (32) ;
un processeur (34) ; et
un programme (36) de détermination d'une tension négative de blocage d'un transistor de commutation (70), stocké dans la mémoire (32) et exécutable sur le processeur (34),
dans lequel le processeur (34) est configuré pour mettre en œuvre, lors de l'exécution du programme (36) de détermination de la tension négative de blocage du transistor de commutation (70), un procédé selon la revendication 1 ou 2.

5. Support de stockage lisible par ordinateur, sur lequel est stocké un programme (36) de détermination d'une tension négative de blocage d'un transistor de commutation (70), dans lequel le programme (36) de détermination de la tension négative de blocage du transistor de commutation (70), lorsqu'il est exécuté par un processeur (34), met en œuvre un procédé selon la revendication 1 ou 2.

6. Circuit de commande de pilotage de transistor de commutation (50), comprenant :

une alimentation de pilotage (52) ; une unité de pilotage (54) ; et
une unité de commande (56), dans lequel :

l'unité de commande (56) est configurée pour acquérir un intervalle de tension négative de blocage d'un transistor de commutation (70) en mettant en œuvre un procédé selon la revendication 1 ou 2, et pour commander l'alimentation de pilotage (52) afin de fournir une tension négative de blocage à l'unité de pilotage (54) sur la base de l'intervalle de tension négative de blocage ; et
l'unité de pilotage (54) est configurée pour piloter, en réponse à la réception d'un signal de commande de blocage, le transistor de commutation (70) de manière à le bloquer sur la base de la tension négative de blocage.

7. Circuit de commande de pilotage de transistor de commutation (50) selon la revendication 6, dans lequel l'unité de pilotage (54) comprend :

une puce de pilotage (U1, U2) ayant une broche d'alimentation positive (VDD) connectée à une borne d'alimentation en tension positive d'amorçage (VDD1, VDD2) de l'alimentation de pilotage (52), et ayant une broche d'alimentation négative (VSS) connectée à une borne d'alimentation en tension négative de blocage (VSS1, VSS2) de l'alimentation de pilotage (52), et une broche d'entrée (IN) de la puce de pilotage connectée à l'unité de commande (56) pour recevoir le signal de commande de blocage envoyé par l'unité de commande (56) ; et
une première résistance de grille ayant une borne connectée à une broche de sortie (OUT) de la puce de pilotage (U1, U2), et ayant une autre borne connectée à une grille du transistor de commutation (70).

8. Circuit de commande de pilotage de transistor de commutation (50) selon la revendication 7, dans lequel l'unité de pilotage (54) comprend en outre :

une première diode ayant une cathode connectée à la borne de la première résistance de grille ; et

une seconde résistance de grille ayant une borne connectée à une anode de la première diode, et ayant une autre borne connectée à l'autre borne de la première résistance de grille.

9. Circuit de commande de pilotage de transistor de commutation (50) selon la revendication 8, dans lequel l'unité de pilotage (54) comprend en outre :
une seconde diode ayant une cathode connectée à la borne de la première résistance de grille et ayant une anode connectée à une cathode de la première diode.

10. Circuit de commande de pilotage de transistor de commutation (50) selon l'une quelconque des revendications 7 à 9, dans lequel l'unité de pilotage (54) comprend en outre :

la première diode ayant la cathode connectée à la borne de la première résistance de grille et l'anode connectée à l'autre borne de la première résistance de grille ; et
la seconde résistance de grille ayant la borne connectée à l'anode de la première diode, et l'autre borne connectée à la grille du transistor de commutation (70).

11. Circuit de commande de pilotage de transistor de commutation (50) selon l'une quelconque des revendications 7 à 10, dans lequel l'unité de pilotage (54) comprend en outre :

un premier condensateur de couplage ayant une borne connectée à la borne d'alimentation en tension positive d'amorçage (VDD1, VDD2) de l'alimentation de pilotage (52) ; et
un second condensateur de couplage ayant une borne connectée à une autre borne du premier condensateur de couplage, et une autre borne connectée à la borne d'alimentation en tension négative de blocage (VSS1, VSS2) de l'alimentation de pilotage (52).

12. Circuit de commande de pilotage de transistor de commutation (50) selon la revendication 11, dans lequel :

lorsque le transistor de commutation (70) est un transistor de commutation de bras supérieur (Q1), un nœud entre le premier condensateur de couplage et le second condensateur de couplage est connecté à un point médian d'un bras de pont au niveau duquel se trouve le transistor de commutation de bras supérieur (Q1) ; et
lorsque le transistor de commutation (70) est un transistor de commutation de bras inférieur (Q2), un nœud entre le premier condensateur de couplage et le second condensateur de couplage est mis à la masse.

13. Système de commande de moteur (100), comprenant un circuit de commande de pilotage de transistor de commutation (50) selon l'une quelconque des revendications 6 à 12.

14. Compresseur (200), comprenant un système de commande de moteur (100) selon la revendication 13.

15. Véhicule (300), comprenant un compresseur (200) selon la revendication 14.

| | S11 |
| --- | --- |
| Determining a first turn-off negative voltage model and a second turn-off negative voltage model | |

| | S13 |
| --- | --- |
| Acquiring a turn-off gate resistance and a turn-on gate resistance of the switching transistor, a bus voltage, and a minimum turn-on voltage and a maximum bearable negative voltage absolute value of the switching transistor | |

| | S15 |
| --- | --- |
| Inputting the turn-off gate resistance, the turn-on gate resistance, the bus voltage, and the minimum turn-on voltage into the first turn-off negative voltage model to obtain a turn-off negative voltage upper limit absolute value of the switching transistor, and inputting the turn-off gate resistance, the turn-on gate resistance, the bus voltage, and the maximum bearable negative voltage absolute value into the second turn-off negative voltage model to obtain a turn-off negative voltage lower limit absolute value of the switching transistor | |

| | S17 |
| --- | --- |
| Determining a turn-off negative voltage interval of the switching transistor based on the turn-off negative voltage upper limit absolute value and the turn-off negative voltage lower limit absolute value | |

FIG. 1

FIG. 2

FIG. 3

Setting a negative value of the turn-off negative voltage upper limit absolute value as an upper limit voltage of the turn-off negative voltage, and setting a negative value of the turn-off negative voltage lower limit absolute value as a lower limit voltage of the turn-off negative voltage — S171

Determining the turn-off negative voltage interval based on the turn-off negative voltage upper limit voltage and the turn-off negative voltage lower limit voltage — S173

FIG. 4

10

Apparatus for determining a
turn-off negative voltage of a
switching transistor

First determining
module — 12

Acquiring module — 14

Second determining
module — 16

FIG. 5

30

Inverter

Memory

36 — Program for
determining a
turn-off
negative
voltage — 32

Processor — 34

FIG. 6

FIG. 7

FIG. 8

FIG. 9

FIG. 10

FIG. 11

100

Motor control system

Switching transistor drive control circuit — 50

FIG. 12

200

Compressor

Motor control system — 100

FIG. 13

300

Vehicle

Compressor — 200

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210360280

- CN 109831197 A